# EUROPEAN PATENT APPLICATION

(11) **EP 4 692 278 A1**
(43) Date of publication of application: **11.02.2026**
(21) Application number: 24778743.5
(22) Date of filing: 09.02.2024
(51) Int. Cl.: C09K 11/08, C01F 17/36, C09K 11/85, H01L 31/055, H10K 30/15, H10K 30/50, H10K 30/60

(54) **CORE-SHELL TYPE UPCONVERTING MICROPARTICLE, UPCONVERTING MICRO PRECURSOR PARTICLE, SENSITIZING CORE-SHELL TYPE UPCONVERTING MICROPARTICLE, TIO2-COATED CORE-SHELL TYPE UPCONVERTING MICROPARTICLE, NEAR-INFRARED DETECTOR, PHOTOELECTRIC CONVERSION ELEMENT, AND METHOD FOR PRODUCING CORE-SHELL TYPE UPCONVERTING MICROPARTICLE**

(30) Priority: 31.03.2023 JP 2023058703
(71) Applicant: Japan Science and Technology Agency, Kawaguchi-shi, Saitama 332-0012 (JP)
(72) Inventor: NIHEI, Ayumi, Tokyo 169-8555 (JP)
(74) Representative: Gilani, Anwar
(86) International application number: PCT/JP2024/004677
(87) International publication number: WO 2024/202598

(57) **Abstract**

A core-shell type upconverting microparticle is an upconverting particle that includes: a core portion; and a shell portion that covers the core portion, the particle has a hexagonal columnar shape, a particle diameter of equal to or greater than 300 nm, and a thickness of equal to or greater than 100 nm, and an aspect ratio as the particle diameter/the thickness is equal to or greater than 1.2 and equal to or less than 5.0.

## Description

### [Technical Field]

The present invention relates to a core-shell type upconverting microparticle, an upconverting micro precursor particle, a sensitizing core-shell type upconverting microparticle, a TiO₂-coated core-shell type upconverting microparticle, a near-infrared detector, a photoelectric conversion element, and a method of manufacturing a core-shell type upconverting microparticle.

Priority is claimed on Japanese Patent Application No. 2023-058703, filed March 31, 2023, the content of which is incorporated herein by reference.

### [Background Art]

Photoelectric conversion elements such as solar cells and photodiodes have widely been used in various fields. However, the conventional photoelectric conversion elements have a problem in that detection sensitivity for light in a near-infrared region is lower than detection sensitivity for light in a visible light region. Photoelectric conversion efficiency can be improved in solar cells, for example, if the detection sensitivity for light in the near-infrared region can also be raised similarly to that for visible light. Therefore, photoelectric conversion elements having high detection sensitivity for light in the near-infrared region as well similarly to that for visible light have been required.

Patent Document 1 discloses a technology using upconverting particles as an inorganic porous material for supporting an organic-inorganic composite perovskite compound as a power generation layer. Here, the upconverting refers to a phenomenon in which low-energy light (long-wavelength light, for example infrared light) is converted into high-energy light (short-wavelength light, for example, visible light or ultraviolet light). The upconverting particles refer to particles having a function of converting long-wavelength light such as infrared light into short-wavelength light such as visible light or ultraviolet light (upconverting light emission). According to the technology, long-wavelength light such as near-infrared light absorbed by inorganic core-shell particles is converted into short-wavelength light such as visible light or ultraviolet light, and the short-wavelength light is reabsorbed by an organic-inorganic composite perovskite crystal to thereby excite energy and generate an electromotive force.

### [Citation List]

### [Patent Document]

[Patent Document 1]
Japanese Unexamined Patent Application, First Publication No. 2015-92563

### [Summary of Invention]

### [Technical Problem]

Currently, upconverting particles that exhibit upconverting light emission even under low excitation light such as sunlight irradiation and exhibit a good sensitization characteristic to weak light having long wavelengths are required. In addition, although many upconverting particles have been manufactured by a hydrothermal method in the related art, synthesis is performed under high temperature and high pressure conditions in the method, and using a simpler and lower-cost manufacturing method has thus been required.

Under such circumstances, the inventor of the present application has found an upconverting micro precursor particle exhibiting a high light emission quantum yield by employing a sol-gel method and intensively working while paying attention to the size and the shape of the crystal particle and the core-shell structure, and has also found a method capable of suppressing energy deactivation through construction of a defect-free crystal structure and shell formation, this led to the present invention.

The present invention is an invention that was made in view of the above circumstances, and an object thereof is to provide a core-shell type upconverting microparticle, a sensitizing core-shell type upconverting microparticle, a TiO₂-coated core-shell type upconverting microparticle, an upconverting micro precursor particle, a near-infrared detector, a photoelectric conversion element, and a method of manufacturing a core-shell type upconverting microparticle, which enable upconverting light emission even under low excitation light such as sunlight irradiation, can obtain better sensitization characteristics using weak light having a long wavelength, and can be manufactured inexpensively. Note that in the following description, the above "core-shell type upconverting microparticle" may be simply referred to as an "upconverting particle".

### [Solution to Problem]

In order to solve the above problem, the present invention proposes the following means.
<1> A core-shell type upconverting microparticle according to a first aspect of the present invention is an upconverting particle including: a core portion; and a shell portion that covers the core portion, in which the particle has a hexagonal columnar shape, a particle diameter of equal to or greater than 300 nm, and a thickness of equal to or greater than 100 nm, and an aspect ratio as the particle diameter/the thickness is equal to or greater than 1.2 and equal to or less than 5.0.
<2> According to a second aspect of the present invention, in the core-shell type upconverting microparticle according to the first aspect, the particle diameter may be equal to or greater than 500 nm, and the thickness may be equal to or greater than 300 nm.
<3> According to a third aspect of the present invention, in the core-shell type upconverting microparticle according to the first aspect or the second aspect, the aspect ratio may be equal to or greater than 1.2 and equal to or less than 3.0.
<4> According to a fourth aspect of the present invention, in the core-shell type upconverting microparticle according to any one of the first to third aspects, the aspect ratio may be equal to or greater than 1.5 and equal to or less than 2.0.
<5> According to a fifth aspect of the present invention, in the core-shell type upconverting microparticle according to any one of the first to fourth aspects, a shell/core ratio that is a ratio of a width of the shell portion and a diameter length of the core portion of the upconverting particle may be equal to or greater than 0.01 and equal to or less than 10.00.
<6> According to a sixth aspect of the present invention, in the core-shell type upconverting microparticle according to the fifth aspect, the shell/core ratio may be equal to or greater than 0.10 and equal to or less than 2.00.
<7> According to a seventh aspect of the present invention, in the core-shell type upconverting microparticle according to any one of the first to sixth aspects, a crystal lattice as a host of the core portion and a crystal lattice as a host of the shell portion may be composed of a same component, the core portion may contain doped rare earth atoms as guests, and the shell portion may not contain doped rare earth atoms.
<8> According to an eighth aspect of the present invention, in the core-shell type upconverting microparticle according to the seventh aspect, the shell portion may not cause energy transfer.
<9> According to a ninth aspect of the present invention, in the core-shell type upconverting microparticle according to the seventh aspect, the core portion may contain both light-absorbing sensitizing atoms and light-emitting activating atoms as the doped rare earth atoms.
<10> According to a tenth aspect of the present invention, in the core-shell type upconverting microparticle according to the ninth aspect, the light-absorbing sensitizing atoms may be trivalent rare earth atoms that have an f orbital energy level, and absorb near-infrared light and cause an electron in a ground state to be excited to the f orbital energy level, and the light-emitting activating atoms may be trivalent rare earth atoms that have a plurality of energy levels, cause multiphoton multistep excitation by energy at the f orbital energy level that the light-absorbing sensitizing atoms have after the excitation being passed, consequently excite an electron to a high energy level corresponding to an energy of equal to or greater than the f orbital energy level through the multiphoton multistep excitation, which is required for light emission in a visible light region, and enable the electron excited to the high energy level to emit light in the visible light region as light of the energy of equal to or greater than the f orbital energy level by accompanying light emission when the electron returns to the ground state.
<11> According to an eleventh aspect of the present invention, in the core-shell type upconverting microparticle according to the ninth aspect, the crystal lattice may be NaYF₄, the light-absorbing sensitizing atoms may be one or more kinds selected from the group consisting of Yb and Nd, and the light-emitting activating atoms may be one or more kinds selected from the group consisting of Tm, Er, and Ho.
<12> According to a twelfth aspect of the present invention, in the core-shell type upconverting microparticle according to the seventh aspect, Nd may be contained as the doped rare earth atom.
<13> According to the thirteenth aspect of the present invention, in the core-shell type upconverting microparticles according to the seventh aspect, the doped rare earth atoms may be a pair of either both Nd and Yb atoms or both Tm and Yb atoms.
<14> According to a fourteenth aspect of the present invention, in the core-shell type upconverting microparticle according to the first aspect, a crystal lattice as a host of the core portion and a crystal lattice as a host of the shell portion may be composed of a same component, the core portion may contain first doped rare earth atoms as guests, and the shell portion may contain second doped rare earth atoms, which are different from the first doped rare earth atoms of the core portion, as guests.
<15> According to a fifteenth aspect of the present invention, in the core-shell type upconverting microparticle according to the fourteenth aspect, the shell portion may cause energy transfer.
<16> According to a sixteenth aspect of the present invention, in the core-shell type upconverting microparticle according to the fourteenth aspect, both light-absorbing sensitizing atoms and light-emitting activating atoms may be contained as the first doped rare earth atoms or the second doped rare earth atoms.
<17> According to a seventeenth aspect of the present invention, in the core-shell type upconverting microparticle according to the sixteenth aspect, the light-absorbing sensitizing atoms may be one or more kinds selected from the group consisting of Yb and Nd, and the light-emitting activating atoms may contain one or more kinds selected from the group consisting of Tm, Er, and Ho.
<18> According to an eighteenth aspect of the present invention, in the core-shell type upconverting microparticle according to the fourteenth aspect, the first doped rare earth atoms or the second doped rare earth atoms may contain Nd.
<19> According to a nineteenth aspect of the present invention, in the core-shell type upconverting microparticle according to the fourteenth aspect, the crystal lattice may be NaYF₄, the first doped rare earth atoms may be a pair of either both Nd and Yb atoms or both Tm and Yb atoms, and the second doped rare earth atoms may be a pair of both Nd and Yb atoms or both Tm and Yb atoms, which is a pair different from the first doped rare earth atoms.
<20> According to a twentieth aspect of the present invention, in the core-shell type upconverting microparticle according to the fourteenth aspect, in order to cause energy transfer from the first doped rare earth atoms to the second doped rare earth atoms, a first energy level that is an energy level of the first doped rare earth atoms may be different from a second energy level that is an energy level of the second doped rare earth atoms.
<21> According to a twenty-first aspect of the present invention, in the core-shell type upconverting microparticle according to the twentieth aspect, third doped rare earth atoms that are doped rare earth atoms that are different from the first doped rare earth atoms and the second doped rare earth atoms may be further present as guests of at least one of the core portion and the shell portion, and a third energy level that is an energy level of the third doped rare earth atoms may be located between the energy level of the first doped rare earth atoms and the energy level of the second doped rare earth atoms.
<22> According to a twenty-second aspect of the present invention, in the core-shell type upconverting microparticle according to the twenty-first aspect, the second doped rare earth atoms may have a plurality of energy levels after excitation at positions higher than an energy level before excitation at which the second doped rare earth atoms receive energy transferred from the first doped rare earth atoms or the third doped rare earth atoms, and an energy gap between the energy level before excitation and one of the energy levels after excitation is equal to the transferred energy.
<23> According to a twenty-third aspect of the present invention, in the core-shell type upconverting microparticle according to the first aspect, doped rare earth atoms may be contained, the doped rare earth atoms may be both light-absorbing sensitizing atoms and light-emitting activating atoms, the light-absorbing sensitizing atoms may be trivalent rare earth atoms that have an f orbital energy level, and absorb near-infrared light and cause an electron in a ground state to be excited to the f orbital energy level, and the light-emitting activating atoms may be trivalent rare earth atoms that have a plurality of energy levels, cause multiphoton multistep excitation by energy at the f orbital energy level that the light-absorbing sensitizing atoms have after the excitation being passed, consequently excite an electron to a high energy level corresponding to an energy of equal to or greater than the f orbital energy level through the multiphoton multistep excitation, which is required for light emission in a visible light region, and enable the electron excited to the high energy level to emit light in the visible light region as light of the energy of equal to or greater than the f orbital energy level by accompanying light emission when the electron returns to the ground state.
<24> According to a twenty-fourth aspect of the present invention, in the core-shell type upconverting microparticle according to the twenty-third aspect, the light-absorbing sensitizing atoms may be Yb, the light-emitting activating atoms may be Er, and the multiphoton multistep excitation may be two-photon two-step excitation.
<25> According to a twenty-fifth aspect of the present invention, in the core-shell type upconverting microparticle according to the twenty-third aspect, the light-absorbing sensitizing atoms may be Yb, the light-emitting activating atoms may be Tm, and the multiphoton multistep excitation may be three-photon three-step excitation.
<26> According to a twenty-sixth aspect of the present invention, in the core-shell type upconverting microparticle according to the twenty-third aspect, the light-absorbing sensitizing atoms may be Yb, the light-emitting activating atoms may be Tm, and the multiphoton multistep excitation may be two-photon two-step excitation.
<27> According to a twenty-seventh aspect of the present invention, in the core-shell type upconverting microparticle according to the twenty-third aspect, one of the light-absorbing sensitizing atoms may be Nd, and the other light-absorbing sensitizing atoms may be one or more kinds selected from the group consisting of Er, Tm, and Ho.
<28> A sensitizing core-shell type upconverting microparticle according to a twenty-eighth aspect of the present invention is an upconverting particle including: a core portion; and a shell portion that covers the core portion, the particle may have a hexagonal columnar shape, a particle diameter of equal to or greater than 500 nm, and a thickness of equal to or greater than 300 nm, and an aspect ratio as the particle diameter/the thickness may be equal to or greater than 1.2 and equal to or less than 3.0, the core portion may contain a pair of either both Nd and Yb atoms or both Tm and Yb atoms, and the shell portion may contain a pair of both Nd and Yb atoms or both Tm and Yb atoms, which is different from the pair included in the core portion.
<29> According to a twenty-ninth aspect of the present invention, in the sensitizing core-shell type upconverting particle according to the twenty-eighth aspect, the core portion may contain both Nd and Yb atoms, and the shell portion may contain both Tm and Yb atoms.
<30> According to a thirtieth aspect of the present invention, in the sensitizing core-shell type upconverting microparticle according to the twenty-eighth aspect, the core portion may contain both Tm and Yb atoms, and the shell portion may contain both Nd and Yb atoms.
<31> A photoelectric conversion element according to a thirty-first aspect of the present invention includes: a transparent conductive film that serves as a negative electrode; a TiO₂ layer that contains the sensitizing core-shell type upconverting microparticle according to the twenty eighth aspect; an electrolyte layer; a hole transport layer; and an Ag layer that serves as a positive electrode being stacked in this order.
<32> In a TiO₂-coated core-shell type upconverting microparticle according to a thirty-second aspect of the present invention, an outermost layer of the sensitizing core-shell type upconverting microparticle according to the twenty-eighth aspect or the core-shell type upconverting microparticle according to the first aspect is a TiO₂ layer composed of TiO₂.
<33> A near-infrared detector according to the thirty-third aspect of the present invention includes, in a photoelectric conversion layer: a layer formed of the TiO₂-coated core-shell type upconverting microparticle according to the thirty-second aspect.
<34> A near-infrared detector according to a thirty-fourth aspect of the present invention includes, in a photoelectric conversion layer: a TiO₂ layer that contains either the sensitizing core-shell type upconverting microparticle according to the twenty-eighth aspect or the core-shell type upconverting microparticle according to the first aspect.
<35> A photoelectric conversion element according to a thirty-fifth aspect of the present invention includes: a transparent conductive film that serves as a negative electrode; a layer formed of the TiO₂-coated core-shell type upconverting microparticle according to the thirty-second aspect; an electrolyte layer or a hole transport layer; and an Ag layer that serves as a positive electrode being stacked in this order.
<36> A method of manufacturing the core-shell type upconverting microparticle according to a thirty-sixth aspect of the present invention is a method of manufacturing the core-shell type upconverting microparticle according to the first aspect including: a first step of forming the core portion by causing a crystal to grow under a condition of a range of 50°C to 500°C by a sol-gel method; and a second step of causing a crystal constituting the shell portion to grow on a surface of the core portion by a sol-gel method under a condition of a range of 50°C to 500°C.
<37> According to a thirty-seventh aspect of the present invention, in the method of manufacturing the core-shell type upconverting microparticle according to the thirty-sixth aspect, crystal growth in the first step may be performed by a heating operation including formation of a cubic crystal and phase transition from the cubic crystal to a hexagonal crystal.
<38> According to a thirty-eighth aspect of the present invention, in the method of manufacturing the core-shell type upconverting microparticle according to the thirty-seventh aspect, the heating operation in the first step may be performed until an integrated temperature as a heating condition for the phase transition exceeds an integrated temperature as a heating condition for the formation of the cubic crystal.
<39> According to a thirty-ninth aspect of the present invention, in the method of manufacturing the core-shell type upconverting microparticle according to the thirty-seventh aspect, the heating operation in the first step may be performed with a degassing operation for maintaining a preset degree of vacuum.
<40> According to a fortieth aspect of the present invention, in the method of manufacturing the core-shell type upconverting microparticle according to the thirty-sixth aspect, a crystal lattice constituting the core portion and a crystal lattice constituting the shell portion may be composed of a same component.
<41> An upconverting micro precursor particle according to a forty-first aspect of the present invention is a central particle capable of serving as the core portion included in the core-shell type upconverting microparticle according to the first aspect, the particle has a hexagonal columnar shape, a particle diameter of equal to or greater than 300 nm, and a thickness of equal to or greater than 100 nm, and an aspect ratio as the particle diameter/the thickness is equal to or greater than 1.2 and equal to or less than 5.0.
<42> According to a forty-second aspect of the present invention, in the upconverting micro precursor particle according to the forty-first aspect, a crystal may be caused to grow by a sol-gel method under a condition of a range of 50°C to 500°C.
<43> According to a forty-third aspect of the present invention, in the upconverting micro precursor particle according to the forty-second aspect, a long-chain organic molecule used as a gelling agent in the sol-gel method may remain on or adhere to and be present on a surface of the particle even after crystal growth by a heating operation.

### [Advantageous Effects of Invention]

According to each of the above aspects of the present invention, it is possible to provide an upconverting particle, an upconverting micro precursor particle, a sensitizing core-shell type upconverting particle, a TiO₂-coated core-shell type upconverting particle, a near-infrared detector, a photoelectric conversion element, and a method of manufacturing an upconverting particle, which enable upconverting light emission even under low excitation light such as sunlight irradiation, can obtain better sensitization characteristics using weak light having a long wavelength, and can be manufactured inexpensively.

### [Brief Description of Drawings]

FIG. 1 is a schematic diagram of a core-shell type upconverting microparticle according to a first embodiment.
FIG. 2 is a schematic sectional view of the core-shell type upconverting microparticle in FIG. 1 taken along the line A-A.
FIG. 3 is a flowchart of a method of manufacturing the core-shell type upconverting microparticle according to the first embodiment.
FIG. 4 is a sectional view of a photoelectric conversion element including the core-shell type upconverting microparticle according to the first embodiment.
FIG. 5 is a diagram illustrating a structure of an energy band in each layer during an operation of a photoelectric conversion element 100 including the core-shell type upconverting microparticle according to the first embodiment.
FIG. 6 is a sectional view of a modification example of the photoelectric conversion element including the core-shell type upconverting microparticle according to the first embodiment.
FIG. 7 is a schematic diagram of a core-shell type upconverting microparticle according to a second embodiment.
FIG. 8 is a schematic sectional view of the core-shell type upconverting microparticle in FIG. 7 taken along the line B-B.
FIG. 9 is a flowchart of a method of manufacturing the core-shell type upconverting microparticle according to the second embodiment.
FIG. 10 is a sectional view of a photoelectric conversion element including the core-shell type upconverting microparticle according to the second embodiment.
FIG. 11 is a schematic diagram of a core-shell type upconverting microparticle according to a third embodiment.
FIG. 12 is a schematic sectional view of the core-shell type upconverting microparticle in FIG. 11 taken along the line C-C.
FIG. 13 is a flowchart of a method of manufacturing the core-shell type upconverting microparticle according to the third embodiment.
FIG. 14 is a sectional view of a photoelectric conversion element according to the present invention including the core-shell type upconverting microparticle according to the third embodiment.
FIG. 15 shows XRD patterns of core portions (that is, upconverting micro precursor particles serving as central particles) contained in core-shell type upconverting microparticles of Example 3-2 and cubic crystal (α-phase) particles of Comparative Example 2.
FIG. 16 shows SEM images of Example 1 (upconverting micro precursor particles), Comparative Example 1-1 (nanoparticles), and Comparative Example 1-2 (cubic crystal (α-phase) particles).
FIG. 17 shows FT-IR spectra of Example 1 (upconverting micro precursor particles) and Comparative Example 1-2 (cubic crystal (α-phase) particles).
FIG. 18 shows light emission spectra of Example 1 (upconverting micro precursor particles) and Comparative Example 1-2 (cubic crystal (α-phase) particles).
FIG. 19 shows XRD patterns of core portions (that is, upconverting micro precursor particles serving as central particles) contained in core-shell type upconverting microparticles of Example 2-2 and cubic crystal (α-phase) particles of Comparative Example 2.
FIG. 20 shows SEM images of Example 2-1 (core) and Comparative Example 2 (cubic crystal (α-phase) particles).
FIG. 21 shows FT-IR spectra of Example 2-1 (core) and Comparative Example 2 (cubic crystal (α-phase) particles).
FIG. 22 shows light emission spectra of Example 2-1 (core) and Comparative Example 2 (cubic crystal (α-phase) particles).
FIG. 23 is XRD patterns of a core and a core shell of Example 3-1.
FIG. 24 is XRD patterns of a core and a core shell of Example 3-2.
FIG. 25 is SEM images of the core and the core shell of Example 3-1.
FIG. 26 is SEM images of the core and the core shell of Example 3-2.
FIG. 27 shows light emission spectra of upconverting particles of core-shell type upconverting microparticles of Example 3-1 and Example 3-2.
FIG. 28 is an SEM image of Example 4.
FIG. 29 is a graph showing a response speed of a photocurrent obtained by a photoelectric conversion element of Example 5.

### [Description of Embodiments]

Hereinafter, a core-shell type upconverting microparticle, an upconverting micro precursor particle, a sensitizing core-shell type upconverting microparticle, a TiO₂-coated core-shell type upconverting microparticle, a near-infrared detector, a photoelectric conversion element, and a method of manufacturing a core-shell type upconverting microparticle according to embodiments to which the present invention is applied will be described in detail using the drawings. Note that in the drawings used in the following description, features may be illustrated in an enlarged manner for convenience in order to facilitate understanding of the features and dimensional ratios and the like of the respective components are not necessarily the same as actual ones. In addition, materials, dimensions, and the like exemplified in the following description are merely examples, the present invention is not limited thereto, and appropriate modifications can be made without changing the gist thereof.

### <First embodiment>

### (Upconverting particle 10)

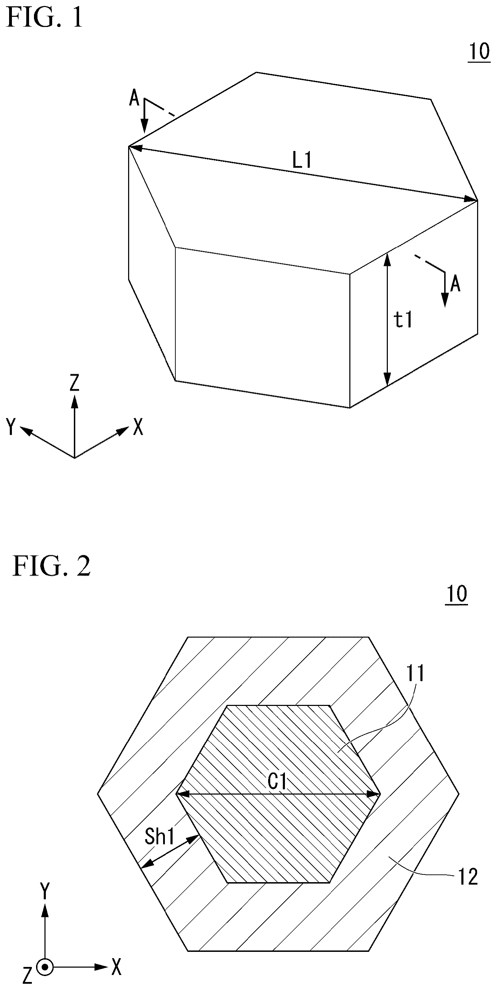

FIG. 1 is a schematic diagram of an upconverting particle 10 according to a first embodiment. FIG. 2 is a schematic sectional view of the upconverting particle 10 in FIG. 1 taken along the line A-A.

The upconverting particle 10 includes a core portion (upconverting micro precursor particle serving as a central particle) 11 and a shell portion (coating layer) 12 that covers the core portion 11. The upconverting particle 10 of the present disclosure is a particle that has a core-shell structure. The particle shape of the upconverting particle 10 is a hexagonal columnar shape.

### "Particle diameter of upconverting particle 10"

A particle diameter L1 of the upconverting particle 10 is equal to or greater than 300 nm. The particle diameter L1 of the upconverting particle 10 is preferably increased in size while maintaining the following aspect ratio in order for the particle to be a particle micronized to a size of at least several hundreds of nanometers or more (that is, a so-called "microparticle") instead of a particle nanosized to a size of several tens of nanometers or less (that is, a so-called "nanoparticle"), and is preferably equal to or greater than 500 nm, for example. A more preferable particle diameter L1 of the upconverting particle 10 is equal to or greater than 550 nm. A particularly preferable particle diameter L1 of the upconverting particle 10 is equal to or greater than 600 nm. The particle diameter L1 of the upconverting particle 10 is preferably equal to or less than 2000 nm. This is because defects are likely to occur in a crystal structure of the particle when the particle diameter L1 is greater than 2000 nm. A more preferable particle diameter L1 of the upconverting particle 10 is equal to or less than 1500 nm. Note that the particle diameter of the core portion 11 is preferably equal to or greater than 300 nm.

Here, the particle diameter L1 of the upconverting particle 10 is a diameter of a minimum enclosing circle that encloses the hexagonal shape (an in-plane direction) of a bottom surface of the upconverting particle 10.

### "Thickness of upconverting particle 10"

A thickness t1 of the upconverting particle 10 is equal to or greater than 100 nm. The amount of adhering organic molecules and the like adhering to the upconverting particle 10 is reduced, and heat deactivation can be suppressed, by the thickness t1 of the upconverting particle 10 being equal to or greater than 100 nm. A more preferable thickness t1 of the upconverting particle 10 is equal to or greater than 300 nm. A thickness t1A of the upconverting particle 10 is equal to or less than 600 nm. Here, the thickness t1 of the upconverting particle 10 is the length of the hexagonal column in the height direction. Similarly, the thickness of the core portion 11 is preferably equal to or greater than 100 nm.

### "Particle diameter L1 of upconverting particle 10/thickness t1 of upconverting particle 10"

An aspect ratio as the particle diameter of the upconverting particle 10/the thickness of the upconverting particle 10 is equal to or greater than 1.2 and equal to or less than 5.0. The particle diameter of the upconverting particle 10/the thickness of the upconverting particle 10 is preferably equal to or greater than 1.5. Similarly, the particle diameter of the core portion 11/the thickness of the core portion 11 is preferably equal to or greater than 1.2 and equal to or less than 5.0.

### "Method of measuring particle diameter and thickness of upconverting particle 10"

The particle diameter and the thickness of the upconverting particle 10 can be measured by the following method. For example, upconverting particles 10 are disposed on a flat substrate and are observed with a scanning electron microscope (SEM) at 15,000 to 30,000 times magnification. Fifteen upconverting particles 10 obtained by the observation are arbitrarily selected, the particle diameters of the upconverting particles 10 are measured from the diameters of the minimum enclosing circles enclosing the hexagonal shapes of the bottom surfaces, and an average value of five intermediate values remaining after excluding the five highest values in a descending order from the highest value to the fifth highest value and the five lowest values in an ascending order from the lowest value to the fifth lowest value is defined as the particle diameter of the upconverting particles 10. Similarly, fifteen upconverting particles 10 obtained by the observation are arbitrarily selected, the heights of the hexagonal columns are measured, and an average value of five intermediate values remaining after excluding the five highest values in a descending order from the highest value to the fifth highest value and five lowest values in an ascending order from the lowest value to the fifth lowest value is defined as the thickness of the upconverting particles 10.

### "Core portion 11"

The core portion 11 has a light wavelength conversion capability. The core portion 11 is preferably formed through crystal growth by the sol-gel method under a condition of a range of 50°C to 500°C. Light emission efficiency is improved by the growth as described above. A long-chain organic molecule used as a gelling agent in the sol-gel method may remain on or adhere to and be present on the surface of the particle even after crystal growth by a heating operation. The core portion 11 is a particle serving as a core of a core-shell type particle (upconverting micro precursor particle serving as a central particle). Here, the light wavelength conversion capability means a capability of converting a wavelength of incident light and emitting light with a wavelength different from that of the incident light. In the present embodiment, a case where the wavelength of incident near-infrared light is converted and emitted as visible light will be described as an example.

Examples of the material of the core portion 11 include materials containing at least one of metals which are rare earth elements capable of emitting excitation light in the visible or ultraviolet region, such as erbium (Er), thulium (Tm), ytterbium (Yb), neodymium (Nd), holmium (Ho), praseodymium (Pr), gadolinium (Gd), europium (Eu), terbium (Tb), samarium (Sm), cerium (Ce), or dysprosium (Dy), or compounds thereof. Note that the light in the visible or ultraviolet region refers to light with a wavelength of less than 700 nm. Examples of the core portion 11 include inorganic fine particles such as NaErF₄, Tm₂O₃, TmCl₃, TmF₃, Er₂O₃, ErCl₃, ErF₃, Ho₂O₃, HoCl₃, and HoF₃, and inorganic fine particles containing rare earth atoms (hereinafter, referred to as doped rare earth atoms in some cases) doped as guests in a crystal lattice as a host. As the core portion 11, an inorganic fine particle containing doped rare earth atoms as guests in a crystal lattice as a host is preferably adopted. As the core portion 11, it is possible to improve efficiency of upconverting light emission by adopting the inorganic fine particle containing the doped rare earth atoms as guests in the crystal lattice as a host.

In a case where the core portion 11 is an inorganic fine particle containing doped rare earth atoms as guests in a crystal lattice as a host, examples of the crystal lattice as the host include simple oxides such as CeO₃ and Y₂O₃, complex halides such as NaYF₄, and complex oxides such as Gd₂O₂S, CaAl₁₂O₁₉, YTa₇O₁₉, GdTa₇O₁₉, and MTa₇O₁₁ (M=Ca, Sr, Ba). As the crystal lattice as the host, a composite halide having low phonon energy such as NaYF₄ and capable of suppressing a loss of excitation energy due to non-radiative transition that inactivates energy to heat without emitting light in an excited state, for example, is preferable.

In a case where the core portion 11 is an inorganic fine particle containing doped rare earth atoms as guests in the crystal lattice as the host, examples of the doped rare earth element include rare earth elements capable of emitting excitation light in the visible or ultraviolet region, such as erbium (Er), thulium (Tm), ytterbium (Yb), neodymium (Nd), holmium (Ho), praseodymium (Pr), gadolinium (Gd), europium (Eu), terbium (Tb), samarium (Sm), cerium (Ce), and dysprosium (Dy). The total content of the doped rare earth atom is preferably 0.5% by mass to 40% by mass with respect to the total mass of the core portion 11. In a case of light-emitting activating atoms, the total content of the light-emitting activating atoms is preferably 0.5% by weight to 2.0% by mass with respect to the total mass of the core portion 11. In a case of light-absorbing sensitizing atoms, the total content of the light-emitting activating atoms is preferably 10% by weight to 40% by mass with respect to the total mass of the core portion 11. It is possible to suppress collapse of the crystal structure and to improve efficiency of upconverting light emission by the total content of the doped rare earth atoms being 0.5% by mass to 40% by mass with respect to the total mass of the core portion 11.

The core portion 11 preferably contains both the light-absorbing sensitizing atoms and the light-emitting activating atoms as doped rare earth atoms. The light-absorbing sensitizing atoms are atoms that receive energy from the outside of the light-absorbing sensitizing atoms and mediate energy to other atoms (for example, the light-emitting activating atoms). The light-emitting activating atoms are atoms that receive energy from the outside of the light-emitting activating atoms and emit light at a predetermined wavelength. The light-absorbing sensitizing atoms are, for example, one or more kinds selected from the group consisting of Yb and Nd. The light-absorbing sensitizing atoms are, for example, both Yb or both Yb and Nd atoms. Although the core portion 11 may contain only one kind of rare earth atoms such as Yb and Nd, the core portion 11 preferably contains two or more kinds of rare earth atoms because light emission efficiency is further improved. The light-absorbing sensitizing atoms are preferably trivalent rare earth atoms that have an f orbital energy level, absorb near-infrared light (wavelength of 800 nm to 2500 nm), and excite an electron in a ground state to the f orbital energy level. The light-emitting activating atoms are preferably trivalent rare earth atoms that have a plurality of energy levels, cause multiphoton multistep excitation by energy at the f orbital energy level that the light-absorbing sensitizing atoms have after the light-absorbing sensitizing atoms absorb near-infrared light and are excited to the f orbital energy level being passed, consequently excite an electron to a high energy level corresponding to an energy of equal to or greater than the f orbital energy level through the multiphoton multistep excitation, which is required for light emission in a visible light region, and enable the electron excited to the high energy level to emit light in the visible light region as light of the energy of equal to or greater than the f orbital energy level by accompanying light emission when the electron returns to the ground state. Note that the multiphoton multistep excitation refers to a phenomenon in which molecules or the like absorb a plurality of photons at substantially the same time and further excitation or the like thereby occurs from the excited level or a relaxed level after the excitation. The light-absorbing sensitizing atoms are, for example, one or more kinds selected from the group consisting of Tm, Er, and Ho. The light-absorbing sensitizing atoms are preferably Yb, the light-emitting activating atoms are preferably Er, and the aforementioned multiphoton multistep excitation is preferably two-photon two-step excitation. The light-absorbing sensitizing atoms are preferably Yb, the light-emitting activating atoms are preferably Tm, and the aforementioned multiphoton multistep excitation is preferably three-photon three-step excitation or two-photon two-step excitation. One of the light-absorbing sensitizing atoms is preferably Nd, and the other light-absorbing sensitizing atoms is preferably one or more kinds selected from the group consisting of Er, Tm, and Ho. Examples of such a core portion 11 include inorganic fine particles composed of Gd₂O₂S (hereinafter, referred to as "Gd₂O₂S: Er, Yb" in some cases) doped with Yb³⁺ and Er³⁺, NaYF₄ (hereinafter, referred to as "NaYF₄: Er, Yb" in some cases) doped with Yb³⁺ and Er³⁺, NaYF₄ (hereinafter, referred to as "NaYF₄: Tm, Yb" in some cases) doped with Tm³⁺ and Yb³⁺, and the like. It is particularly preferable that the crystal lattice as a host of the core portion 11 be NaYF₄, both light-absorbing sensitizing atoms and light-emitting activating atoms be contained as guests, the light-absorbing sensitizing atoms be Yb or both Yb and Nd atoms, and the light-emitting activating atoms be one or more kinds selected from the group consisting of Tm, Er, and Ho. The core portion 11 preferably contains Nd as a doped rare earth atom.

In a case where the light-absorbing sensitizing atoms are Yb, the light-emitting activating atoms are Er, and the aforementioned multiphoton multistep excitation is two-photon two-step excitation, it is preferable to cause light emission through processes of (a1) to (d1), namely (a1) energy transition by light absorption at Yb³⁺; (b1) energy transfer from Yb³⁺ to Er³⁺ after energy transition by the light absorption; (c1) energy transition by multiphoton multistep excitation at Er³⁺ after energy transfer from Yb³⁺ to Er³⁺; and (d1) light emission at Er³⁺ after energy transition by multiphoton multistep excitation. Note that in the process of (a1), energy transition from the level of ²F_{7/2} to the level of ²F_{5/2} of Yb³⁺ occurs. In the process of (b1), energy transfer from the level of ²F_{5/2} of Yb³⁺ to the level of ⁴I_{11/2} of Er³⁺ occurs. In the process of (c1), energy transition from the level of ⁴I_{11/2} to the level of ⁴F_{7/2} of Er³⁺ occurs. In the process of (d1), energy transition from the level of ⁴F_{9/2} to the level of ⁴I_{15/2} associated with red light emission of Er³⁺, energy transition from the level of ⁴S_{3/2} to the level of ⁴I_{15/2} associated with green light emission of Er³⁺, and energy transition from the level of ²H_{11/2} to the level of ⁴I_{15/2} associated with green light emission of Er³⁺ occur.

In a case where the light-absorbing sensitizing atoms are Yb, the light-emitting activating atoms are Tm, and the aforementioned multiphoton multistep excitation is four-photon four-step excitation, it is preferable to cause light emission through processes of (a2) to (d2), namely (a2) energy transition by light absorption at Yb³⁺; (b2) energy transfer from Yb³⁺ to Tm³⁺ after energy transition by the light absorption; (c2) energy transition by multiphoton multistep excitation at Tm³⁺ after energy transfer from Yb³⁺ to Tm³⁺; and (d2) light emission at Tm³⁺ after energy transition by multiphoton multistep excitation. Note that in the process of (a2), energy transition from the level of ²F_{7/2} to the level of ²F_{5/2} of Yb³⁺ occurs. In the process of (b2), energy transfer from the level of ²F_{5/2} of Yb³⁺ to the level of ³H₅ of Tm³⁺ occurs. In the process of (c2), energy relaxation from the level of ³H₅ to the level of ³F₄ of Tm³⁺, energy transition from the level of ³F₄ to the level of ³F₂ or ³F₃, energy transition from the level of ³H₄ to the level of ¹G₄, and energy transition from the level of ¹G₄ to the level of ¹D₂ occur. In the process of (d2), energy transition from the level of ¹D₂ to the level of ³H₆ associated with blue light emission of Tm³⁺, energy transition from the level of ¹G₄ to the level of ³H₆ associated with blue light emission of Tm³⁺, and energy transition from the level of ³H₄ to the level of ³H₆ associated with red light emission of Tm³⁺ occur.

In a case where the light-absorbing sensitizing atoms are Nd and Yb and the other light-absorbing sensitizing atoms are one or more kinds selected from the group consisting of Er, Tm, and Ho, it is preferable to undergo processes of (a4) to (c4), namely (a4) energy transition by light absorption at Nd³⁺, (b4) energy transfer from Nd³⁺ to Yb³⁺ after energy transition by light absorption; and (c4) energy transition at Yb³⁺ after energy transfer from Nd³⁺ to Yb³⁺. Note that in the process of (a4), energy transition from the level of ⁴I_{9/2} to the level of ⁴F_{5/2} of Nd³⁺ occurs. In the process of (b4), energy transfer from the level of ⁴F_{3/2} of Nd³⁺ to the level of ²F_{5/2} of Yb³⁺ occurs. In the process of (c4), energy transition from the level of ²F_{7/2} to the level of ²F_{5/2} of Yb³⁺ occurs.

In a case where the light-absorbing sensitizing atoms are Nd and Yb, and the light-emitting activating atoms are Tm, it is preferable to cause light emission through processes of (a4) to (e5), namely (a4) energy transition by light absorption at Nd³⁺, (b4) energy transfer from Nd³⁺ to Yb³⁺ after energy transition by the light absorption, (c4) energy transfer from Yb³⁺ to Tm³⁺ after energy transfer from Nd³⁺ to Yb³⁺, (d4) energy transition by multiphoton multistep excitation at Tm³⁺ after energy transfer from Yb³⁺ to Tm³⁺; and (e5) light emission at Tm³⁺ after energy transition by multiphoton multistep excitation. Note that in the process of (a4), energy transition from the level of ⁴I_{9/2} to the level of ⁴F_{5/2} of Nd³⁺ occurs. In the process of (b4), energy transfer from the level of ⁴F_{3/2} of Nd³⁺ to the level of ²F_{5/2} of Yb³⁺ occurs. In the process of (c4), energy transition from the level of ²F_{7/2} to the level of ²F_{5/2} of Yb³⁺ occurs. In the process of (d4), energy transfer from the level of ²F_{5/2} of Yb³⁺ to the level of ³H₅ of Tm³⁺ occurs. In the process of (c2), energy transition from the level of ³H₅ to the level of ¹G₄ of Tm³⁺, energy relaxation from the level of ¹G₄ to the level of F₂ or ³F₃, energy transition from the level of ³F₂ or ³F₃ to the level of ¹D₂, and energy transition from the level of ¹D₂ to the level of ³P₂ occur. In the process of (d2), energy transition from the level of ¹I₆ to the level of ³H₆ associated with ultraviolet light emission of Tm³⁺, energy transition from the level of ¹D₂ to the level of ³H₆ associated with blue light emission of Tm³⁺, energy transition from the level of ¹G₄ to the level of ³H₆ associated with blue light emission of Tm³⁺, and energy transition from the level of ³H₄ to the level of ³H₆ associated with red light emission of Tm³⁺ occur.

In a case where the core portion 11 contains both light-absorbing sensitizing atoms and light-emitting activating atoms as doped rare earth atoms, the doped rare earth atoms contained as guests in the core portion 11 are preferably a pair of either both Nd and Yb atoms or both Tm and Yb atoms. In other words, the core portion 11 preferably contains both the Nd and Yb atoms as guests, or the core portion 11 preferably contains both Tm and Yb atoms as guests. In a case where Tm and Yb are contained as doped rare earth atoms in the core portion, the molar ratio of Tm and Yb is preferably 10:30 to 30:10. More preferably, the molar ratio of Tm and Yb is 15:25 to 25:15. In a case where Nd and Yb are contained as doped rare earth atoms in the core portion, the molar ratio of Nd and Yb is preferably 10:30 to 30:10. More preferably, the molar ratio of Nd and Yb is 15:25 to 25:15.

A particle diameter (diameter length) C1 of the core portion 11 is preferably 500 nm to 1500 nm. The particle diameter C1 of the core portion 11 is a diameter of a minimum enclosing circle enclosing the hexagonal shape in a plane perpendicular to the height direction of the hexagonal column.

### (Shell portion 12)

The shell portion 12 is a covering layer that covers the core portion 11. A crystal lattice constituting the shell portion 12 is preferably composed of the same component as the crystal lattice as the host of the core portion 11. In a case where the crystal lattice as the host of the core portion 11 is NaYF₄, for example, the crystal lattice of the shell portion 12 is also preferably NaYF₄.

In the first embodiment, the shell portion 12 does not contain doped rare earth atoms, and the shell portion 12 does not cause energy transfer. Since the shell portion 12 in the first embodiment does not contain doped rare earth atoms, the doped rare earth atoms are unevenly distributed in the core portion 11. Thus, even if long-chain organic molecules adhere to the surface during the manufacturing of the upconverting particles 10, for example, the long-chain organic molecules can be separated from the core portion 11, and the vibration deactivation due to the long-chain organic molecules can be suppressed.

A thickness (width) Sh1 of the shell portion 12 is preferably, for example, 100 nm to 500 nm. Note that since a shell/core ratio, which is a ratio of the width of the shell portion/the diameter length of the core portion of the upconverting particle 10, is preferably equal to or greater than 0.01 and equal to or less than 10.00 as will be described later, it is also possible to set the thickness (width) Sh1 of the shell portion 12 to be smaller than a lower limit value of the aforementioned preferable range in accordance with the particle diameter (diameter length) C1 of the core portion 11 in a case where the shell/core ratio is 0.01, for example. Specifically, the thickness (width) Sh1 of the shell portion 12 may be 5 nm when the particle diameter (diameter length) C1 of the core portion 11 is 500 nm, and the thickness (width) Sh1 of the shell portion 12 may be 1 nm when the particle diameter (diameter length) C1 is 100 nm, for example. The thickness (width) Sh1 of the shell portion 12 is a length of the shell portion 12 in a direction perpendicular to the interface between the core portion 11 and the shell portion 12 in a plane perpendicular to the height direction of the hexagonal column.

The coverage of the shell portion 12 with respect to the surface of the core portion 11 is preferably equal to or greater than 50%. The coverage of the shell portion 12 with respect to the surface of the core portion 11 is more preferably 100%.

The shell portion 12 may include a single layer or two or more layers. Even if long-chain organic molecules used as a gelling agent remain on or adhere to and are present on the surface of the particle at the time of the manufacturing of the upconverting particle 10, specifically, after crystal growth by a heating operation in the sol-gel method, for example, it is possible to separate the long-chain organic molecules from the core portion 11 and to suppress vibration deactivation due to the long-chain organic molecules by increasing the number of layers. It is thus possible to improve light emission efficiency of the upconverting particle 10.

Additionally, even if the shell portion 12 includes two or more layers in terms of a manufacturing process, for example, in a case where a first shell layer and a second shell layer have the same composition and both the first shell layer and the second shell layer are integrated to form a shell layer without having a clear interface therebetween, the first shell layer and the second shell layer can be regarded as a single layer together. Such a case is, for example, where presence of the interface between the first shell layer and the second shell layer cannot be observed even using observation by a transmission electron microscope.

The particle diameter (diameter length) C1 of the core portion 11 and the thickness (width) Sh1 of the shell portion 12 can be measured by the following method. The upconverting particles 10 are observed with a scanning electron microscope (SEM) or a transmission electron microscope (TEM), and fifteen upconverting particles 10 are arbitrarily selected. The particle diameters of the core portions 11 and the thicknesses of the shell portions 12 of the selected upconverting particles 10 are measured, and an average value and thickness (width direction) of the particle diameter of five particles, which are intermediate values remaining by excluding five highest values in a descending order from the highest value to the fifth highest value and five values in an ascending order from the lowest value to the fifth lowest value are defined as the particle diameter of the core portions 11 and the thickness (width) of the shell portions 12, respectively.

### (Shell/core ratio, which is the width of shell portion 12/diameter length of core portion 11 of upconverting particle 10)

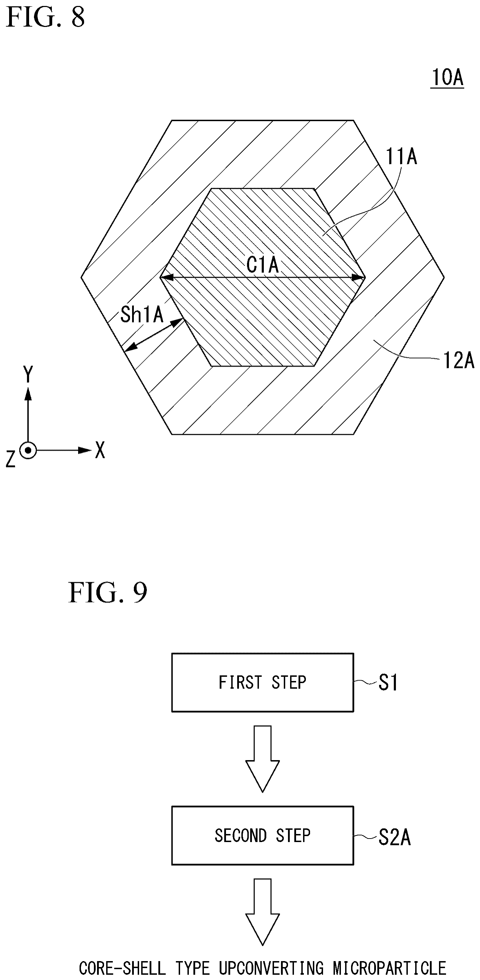

The shell/core ratio, which is the width of the shell portion/the diameter length of the core portion of the upconverting particles 10, is preferably equal to or greater than 0.01 and equal to or less than 10.00. A more preferable shell/core ratio is equal to or greater than 0.10 and equal to or less than 2.00. A yet particularly preferable shell/core ratio is equal to or greater than 0.10 and equal to or less than 1.00. In the case of the upconverting particle illustrated in FIG. 2, for example, the width of the shell portion of the upconverting particle is the value of Sh1, and the diameter length of the core portion is the value of C1. Also, in the case of the upconverting particle illustrated in FIG. 8, the width of the shell portion of the upconverting particle is a value of Sh1A, and the diameter length of the core portion is a value of C1A.

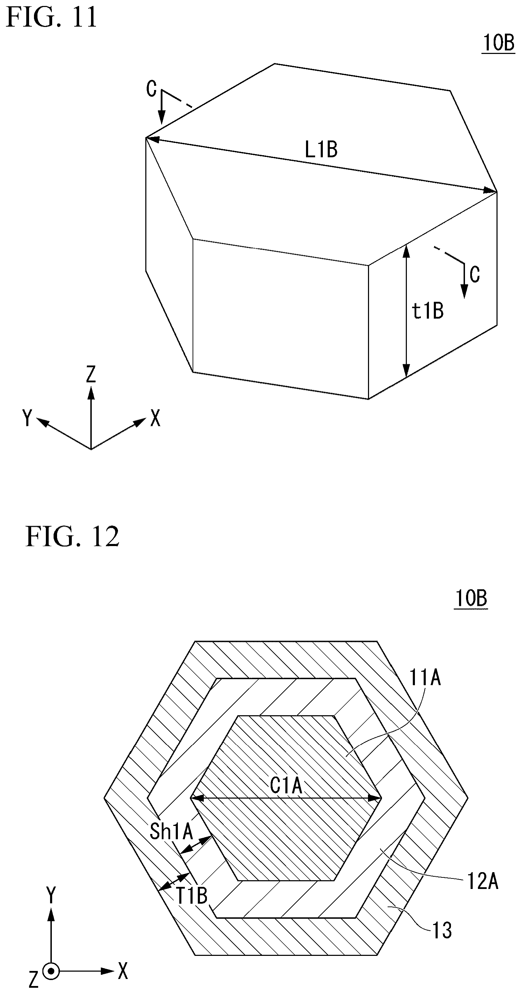

Note that in a case where the shell portion includes a plurality of layers, the width of the shell portion corresponds to the width diameter of the plurality of layers. In the case of the upconverting particle illustrated in FIG. 12, for example, the width of the shell portion of the upconverting particle is a total value of the value of ShlA and the value of T1B, and the diameter length of the core portion is the value of C1A.

Even if long-chain organic molecules used as a gelling agent remain on or adhere to and are present on the surface of the particle at the time of the manufacturing of the upconverting particle 10, for example, specifically, after crystal growth by a heating operation in the sol-gel method, for example, it is possible to separate the long-chain organic molecules from the core portion 11 and to suppress vibration deactivation due to the long-chain organic molecules by the shell/core ratio of the upconverting particle 10 being equal to or greater than 0.01 and equal to or less than 10.00. It is thus possible to improve light emission efficiency of the upconverting particle 10.

In the upconverting particle 10, the outermost layer of the upconverting particle 10 may be a TiO₂ layer composed of TiO₂. In other words, the upconverting particle 10 may include a TiO₂ layer composed of TiO₂ on the surface of the shell portion 12.

### (Method of manufacturing upconverting particle 10)

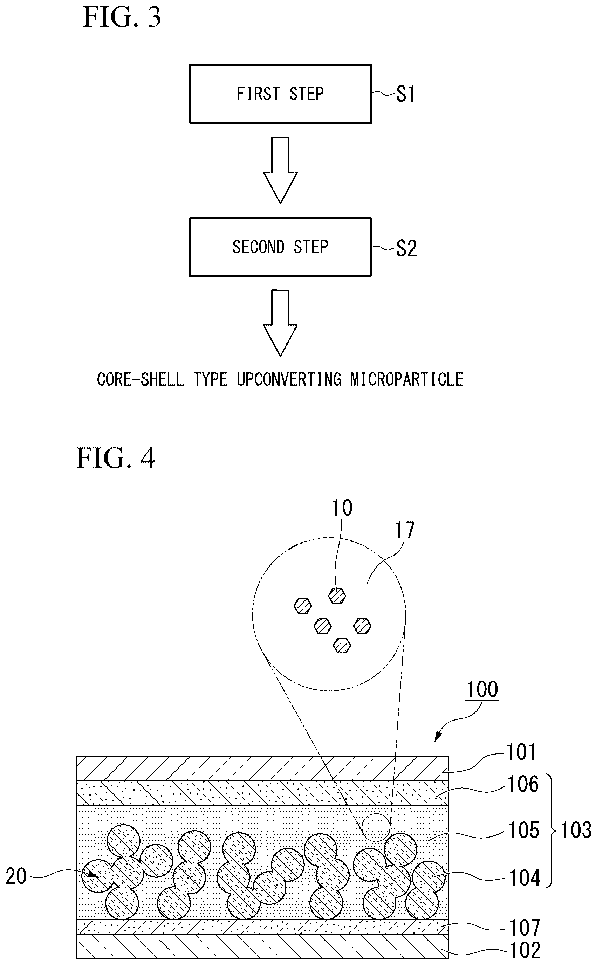

Next, a method of manufacturing the upconverting particle 10 according to the present disclosure will be described. As illustrated in FIG. 3, the method of manufacturing the upconverting particle 10 according to the present invention includes: a first step S1 of forming the core portion 11 by causing a crystal to grow under a condition of a range of 50°C to 500°C by a sol-gel method; and a second step S2 of causing a crystal constituting the shell portion 12 to grow on a surface of the core portion 11 after the first step S1 by a sol-gel method under a condition of a range of 50°C to 500°C. While upconverting particles in the related art are manufactured by a hydrothermal method requiring high temperature and high pressure conditions, the upconverting particle according to the present disclosure is not manufactured under high temperature and high pressure conditions, and it is thus possible to easily manufacture the upconverting particle at low cost.

### "First step S1"

In the first step S1, The core portion 11 is formed through crystal growth by the sol-gel method under a condition of a range of 50°C to 500°C.

Specifically, a trifluoroacetate is synthesized using a rare earth atom oxide such as Y₂O₃, Er₂O₃, Nd₂O₃, Tm₂O₃, Ho₂O₃, Gd₂O₃, or Yb₂O₃, or a rare earth atom halide such as YCl₃, YF₃, ErCl₃, ErF₃, TmCl₃, TmF₃, HoCl₃, HoF₃, GdCl₃, or GdF₃, for example, as a main raw material. The ratio of each material is determined in accordance with the intended composition ratio. Furthermore, sodium trifluoroacetate and an organic molecule having 1 to 3 long-chain hydrocarbon groups having about 8 to 24 carbon atoms, such as 1-octadecene, an oleic acid, oleylamine, trioctylphosphine oxide, a linoleic acid, or octylamine, or a long-chain organic molecule such as a carboxylic acid thereof, for example, are used as a gelling agent, and a reaction is caused in an N₂ or Ar atmosphere at a low temperature condition (50°C to 500°C). The solution after the reaction is cooled, an organic solvent such as ethanol is added as necessary, and the central particle as the core portion 11 is then separated by centrifugation. A main row material of the core portion 11 is appropriately adjusted to include a crystal lattice as a host and doped rare earth atoms as guests. In a case where the crystal lattice as a host is NaYF₄ and the doped rare earth atoms are Nd and Yb, for example, Y₂O₃, Nd₂O₃, and Yb₂O₂ are selected, and the ratio thereof is determined in accordance with the composition ratio of the core portion 11 to be obtained.

The crystal growth in the first step S1 is performed by a heating operation including (a) formation of an α phase (cubic crystal) and (b) phase transition from the α phase (cubic crystal) to a β phase (hexagonal crystal). For example, the heating operation for forming the α phase is performed by raising the temperature from an ordinary temperature to a temperature range (first temperature range) of 80°C to 150°C at a temperature raising speed of about 100°C/4 minutes to 100°C/10 minutes and performing heating processing in the first temperature range for about 10 minutes to 40 minutes. The heating operation for the phase transition from the α phase to the β phase is performed by raising the temperature from the first temperature range to a temperature range of 200°C to 500°C (second temperature range) at a temperature raising speed of about 100°C to 300°C/about 10 minutes to 15 minutes and performing heating processing in the second temperature range for 20 minutes to 80 minutes. Only the β phase can be obtained by performing the heating processing in the second temperature range for 60 minutes or more.

The aforementioned heating operation in the first step S1 is preferably performed until the integrated temperature as a heating condition for the phase transition from the α phase to the β phase exceeds the integrated temperature as a heating condition for the formation of the cubic crystal. This facilitates formation of the upconverting particle 10 having a particle diameter of equal to or greater than 500 nm, a thickness of equal to or greater than 300 nm, and an aspect ratio as the particle diameter/the thickness of equal to or greater than 1.2 and equal to or less than 3.0. The integrated temperature is a sum of the processing temperatures at predetermined time intervals. In a case where the heating processing is performed at a heating temperature (100°C) every 5 minutes during the heating processing for 30 minutes, for example, 100°C × 30/5 = 600°C. The same integrated temperature calculation method is used for the integrated temperature as the heating condition for the phase transition from the α phase to the β phase and the integrated temperature as the heating condition for the formation of the cubic crystal. The heating temperature is, for example, a setting temperature of a heating furnace used for the heating.

The heating operation in the first step S1 is performed with a degassing operation for maintaining a preset degree of vacuum. The degree of vacuum is, for example, 0.1 MPa to 0.01 MPa. This facilitates formation of the upconverting particle 10 having a particle diameter of equal to or greater than 500 nm, a thickness of equal to or greater than 300 nm, and an aspect ratio as the particle diameter/the thickness of equal to or greater than 1.2 and equal to or less than 5.0.

### "Second step S2"

Next, in the second step S2, a crystal constituting the shell portion 12 is caused to grow on the surface of the core portion 11 formed in the first step S1 under a condition of a range of 50°C to 500°C by the sol-gel method. A rare earth atom oxide or a rare earth atom halide is selected and trifluoroacetate is synthesized similarly to the first step such that the component of the crystal lattice constituting the shell portion 12 is the same as the component of the crystal lattice as the host of the aforementioned core portion 11. Next, the core portion 11 obtained in the first step S1, sodium trifluoroacetate, and an organic molecule having 1 to 3 long-chain hydrocarbon groups having about 8 to 24 carbon atoms, such as 1-octadecene, an oleic acid, oleylamine, trioctylphosphine oxide, a linoleic acid, or octylamine, or a long-chain organic molecule such as a carboxylic acid thereof, for example, are used as a gelling agent, and a reaction is caused in an N₂ or Ar atmosphere at a low temperature condition (50°C to 500°C) within 30 minutes. The solution after the reaction is cooled, an organic solvent such as ethanol is added as necessary, and the upconverting particle 10 is then separated by centrifugation. In a case where the shell portion 12 including a plurality of layers is formed around the core portion 11, the upconverting particle 10 including a plurality of layers can be obtained by repeating the above steps. The crystal lattice of the core portion 11 formed in the first step S1 and the crystal lattice of the shell portion 12 formed in the second step S2 are preferably composed of the same component. Even if long-chain organic molecules adhere to the surface of the particle during the manufacturing of the upconverting particle 10, for example, it is possible to separate the long-chain organic molecules from the core portion 11 and to expect an effect of suppressing vibration deactivation due to the long-chain organic molecules, as described above, by the crystal lattice of the core portion 11 formed in the first step S1 and the crystal lattice of the shell portion 12 formed in the second step S2 being composed of the same component.

### (Photoelectric conversion element)

FIG. 4 is a sectional view of a photoelectric conversion element 100 including the upconverting particles 10. The photoelectric conversion element 100 is configured mainly of a positive electrode layer (positive electrode member) 101, a negative electrode layer (negative electrode member) 102, and a photoelectric conversion layer 103 sandwiched therebetween.

### "Negative electrode layer 102"

A buffer layer 107 having E_{cb} as the lowest energy level in a conduction band between E_{c2} and E_{c3} (that is, E_{c2} < E_{cb} < E_{c3}) as the lowest energy level in the conduction band between the negative electrode layer 102 and the photoelectric conversion layer 103 may be sandwiched between the negative electrode layer 102 and the photoelectric conversion layer 103. Examples of a constituent material of the buffer layer 107 include europium oxide (Eu₂O₃), titanium oxide, tin oxide, and the like. Examples of the structure of the buffer layer 107 include a structure obtained by stacking one or more kinds of the constituent materials on the surface of the photoelectric conversion layer 103 on the side of the negative electrode layer 102, for example.

In order to take light into the photoelectric conversion layer 103, the negative electrode layer 102 constituted by a light-transmitting material, for example, a transparent conductive film such as antimony-doped indium oxide (ATO), indium tin oxide (ITO), zinc oxide, tin oxide, or fluorine-doped indium oxide (FTO) is preferably adopted. As the negative electrode layer 102, ATO having heat resistance is preferable.

### "Positive electrode layer 101"

The positive electrode layer 101 may not be transparent, and metal, a conductive polymer, or the like can be used as an electrode material of the electrode. Specific examples of the electrode material include metal such as gold (Au), silver (Ag), aluminum (Al), and zinc (Zn), alloys of two or more thereof, graphite, a graphite interlayer compound, polyaniline and derivatives thereof, and polythiophene and derivatives thereof. Examples of the material of the transparent positive electrode layer 101 include ITO.

### "Photoelectric conversion layer 103"

As illustrated in FIG. 4, the photoelectric conversion layer 103 is preferably obtained by stacking a first layer (electron transport layer) 104 constituted mainly of a plurality of particles (hereinafter, referred to as "inorganic semiconductor particles" in some cases) 20 containing an inorganic semiconductor as a main component, a second layer 105 formed on the surface of the first layer 104, containing an inorganic perovskite substance 17 as a main component, and further constituted by an aggregate or a thin film (composite) containing the upconverting particles 10, and a third layer 106 constituted by a plurality of particles containing an organic or inorganic semiconductor (including a metal complex) as a main component or an aggregate or a thin film of the plurality of particles. In other words, the photoelectric conversion element 100 is preferably configured such that the positive electrode layer 101, the third layer 106, the second layer 105, the first layer 104, and the negative electrode layer 102 are arranged in this order and at least a current path from the positive electrode layer 101 to the negative electrode layer 102 is formed. The photoelectric conversion layer 103 contains the upconverting particles 10 and the inorganic perovskite substance 17. Here, "containing an inorganic semiconductor as a main component" means that the inorganic semiconductor in the particles 20 is contained in an amount in which the inorganic semiconductor can exhibit its function in the present invention, and specifically means that the content of the inorganic semiconductor is greater than 50% by volume, for example. The content is preferably greater than 90% by volume, and it is more preferable that the particles are substantially constituted by the inorganic semiconductor. "Containing the inorganic perovskite substance 17 as a main component" means that the inorganic perovskite substance 17 is contained in an amount in which the inorganic perovskite substance 17 can exhibit its function in the present invention with respect to the total mass of the second layer 105 and specifically means that the content of the inorganic perovskite substance 17 is greater than 50% by volume, for example. The content is preferably equal to or greater than 70% by volume. Furthermore, "containing an organic or inorganic semiconductor (including a metal complex) as a main component" means that the aggregate or the thin film (composite) containing the upconverting particles 10 is contained in an amount in which the aggregate or the thin film (composite) can exhibit its function in the present invention with respect to the total mass of the third layer 106, and specifically means that the content of the aggregate or the thin film (composite) containing the upconverting particles 10 is greater than 50% by mass, for example. The content is preferably greater than 90% by volume, and it is more preferable that the particles are substantially constituted by the organic or inorganic semiconductor (including a metal complex). Although a larger number of current paths to be formed is better, adjacent current paths may be electrically connected to each other or may not be electrically connected to each other. Note that the "layer" in the present embodiment means a film formed in one or a plurality of film forming processes, is not limited to a flat film, and may not be integrated.

Furthermore, the materials and compositions of the three layers 104 to 106 are determined such that energy levels of the lowest conduction bands or the lowest unoccupied molecular orbital (LUMO) energy levels increase in the order of the first layer 104, the second layer 105, and the third layer 106. For example, for the first layer 104, the energy level of the highest valence band can be equal to or greater than -8 eV, and the energy level of the lowest conduction band can be equal to or less than - 4 eV. At this time, for the second layer 105, the energy level of the highest valence band can be equal to or greater than -6.0 eV, and the energy level of the lowest conduction band can be equal to or less than -3 eV. For the third layer 106, the energy level of the lowest conduction band is preferably equal to or less than -2 eV.

The first layer 104 is an aggregation of a plurality of inorganic semiconductor particles 20 formed on the negative electrode layer 102 and is preferably a porous film having a plurality of voids between the inorganic semiconductor particles 20. The inorganic semiconductor particles 20 in contact with the second layer 105 are in direct contact with the negative electrode layer 102 or in an indirect contact therewith via other inorganic semiconductor particles 20 such that the inorganic semiconductor particles 20 are electrically connected to the negative electrode layer 102. It is possible to increase the area of contact with the second layer 105 by including the first layer 104 that is a porous film.

The inorganic semiconductor contained in the inorganic semiconductor particles 20 preferably has an absorption wavelength in the ultraviolet region, and examples thereof include titanium (IV) oxide (TiO₂) and zinc oxide. The inorganic semiconductor particles 20 are, for example, titanium (IV) oxide. In this case, the photoelectric conversion element 100 includes an electron transport layer composed of titanium oxide (IV). The thickness of the first layer 104 is preferably equal to or greater than about 10 nm and equal to or less than 1000 nm and is yet more preferably equal to or greater than about 50 nm and equal to or less than 500 nm.

The second layer 105 is a thin film that covers exposed portions of surfaces of the inorganic semiconductor particles 20, that is, portions that are not in contact with any of the negative electrode layer 102 and the inorganic semiconductor particles 20 in the manufacturing step thereof. Although the second layer 105 does not need to cover the entire exposed portions, the second layer 105 preferably covers at least the exposed portions on the side of the positive electrode layer 101 in order to form the current paths.

The inorganic perovskite substance 17 constituting the second layer 105 is constituted by a plurality of molecules composed of metal cations such as Pb²⁺ and Sn²⁺, halogenated anions such as I⁻, Cl⁻, and Br⁻, and organic cations such as CH₃NH₃⁺ (MA), NH=CHNH₂⁺ (FA), and Cₛ⁺. The size and the shape of the band gap can be changed depending on the number of ions selected from each of the metal cations, the halide anions, and the organic cations. When tin is added to the inorganic perovskite substance 17, the band gap is narrowed, and the inorganic perovskite substance 17 responds to long-wavelength light such as near-infrared light, while the inorganic perovskite substance 17 is easily oxidized in the atmosphere, and the characteristics are degraded. In each molecule constituting the inorganic perovskite substance 17, the halogenated anions are disposed at vertices of a regular octahedron centered on a metal ion, and the organic cations are disposed in the vicinity of a cube centered on the metal ion and containing the regular octahedron therein. Specifically, the regular octahedron formed of the metal ion and the halogenated anions forms a three-dimensional lattice and the organic cations enter gaps therebetween in this structure. Light converted into visible light by the upconverting particles 10 is absorbed by the inorganic perovskite substance 17. It is thus possible to improve conversion efficiency of light in the near-infrared region of the photoelectric conversion element 100.

The content of the upconverting particles 10 in the second layer 105 is preferably equal to or greater than 5% by weight because sensitivity to light in the near-infrared region is improved. The content of the upconverting particles 10 in the second layer 105 is preferably equal to or less than 30% by weight because it becomes difficult to form the perovskite substance if the content thereof is greater than 30% by weight.

In addition, it is preferable that the energy level of the highest valence band of the second layer 105 be lower than the energy level of the highest valence band of the third layer 106 and be intermittently connected to the same energy order. Examples of a composition of the second layer 105 (inorganic perovskite substance 17) satisfying these conditions include CH₃NH₃PbI₃, NH=CHNH₂PbI₃, and CsPbI₃. In addition, examples include halide anions in which the composition ratio of I to Cl or Br is changed.

The third layer 106 may be a thin film that covers the surface (exposed surface) of the inorganic perovskite substance 17 contained in the second layer in a photoelectric conversion element precursor constituted by the first layer 104 and the second layer 105. The third layer 106 is formed of any of a p-type organic semiconductor, an inorganic semiconductor, and an organic metal complex. The thickness of the third layer 106 is preferably, for example, equal to or greater than 1 nm and equal to or less than 100 nm.

Examples of the p-type organic semiconductor constituting the third layer include bathocuproine (BCP), 2,2',7,7'-tetrakis(N,N'-di-p-methoxyphenylamine)-9,9'-spirobifluorene(Spiro-OMeTAD), poly (3,4-ethylenedioxythiophene): poly(styrenesulfonate) (PEDOT: PSS), N,N,N',N'-tetrakis(4-methoxyphenyl)-benzidine (TPD), and the like.

Examples of the p-type inorganic semiconductor constituting the third layer 106 include CuI and CuSCN.

The photoelectric conversion element 100 may include a hole transport layer and an electron transport layer, and a member for the photoelectric conversion element of the present disclosure may be arranged between the hole transport layer and the electron transport layer.

### (Energy band structure)

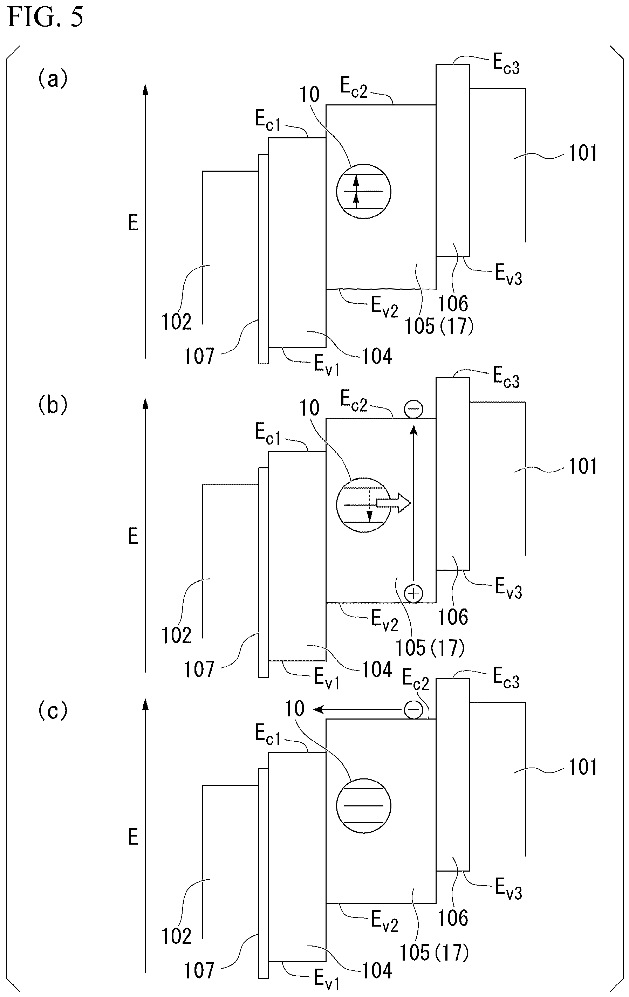

FIGS. 5(a) to 5(c) illustrate a structure of an energy band of each layer during an operation of the photoelectric conversion element 100 according to the present embodiment.

In a state where light irradiation is not performed, the energy level of the lowest conduction band of the third layer 106 is higher than the Fermi level of the positive electrode layer 101 on the side of the positive electrode layer 101, and a current directed from the positive electrode layer 101 to the negative electrode layer 102 is blocked as illustrated in FIG. 5(a).

Once the photoelectric conversion element 100 is irradiated with light having a wavelength of equal to or greater than 700 nm, the upconverting particles 10 constituting the second layer 105 absorb the light and convert the wavelength into that of visible light. Next, the inorganic perovskite substance 17 absorbs the light with the converted wavelength (FIG. 5(b)). Note that the dashed line arrow and a solid line arrow of the upconverting particles 10 in FIG. 5(b) indicate energy of the same magnitude. By absorbing light, the inorganic perovskite substance 17 generates electrons e and holes h, the electrons e move to the conduction band E_{c1}, and the holes h move to the valence band Eᵥ₃ (FIG. 5(c)).

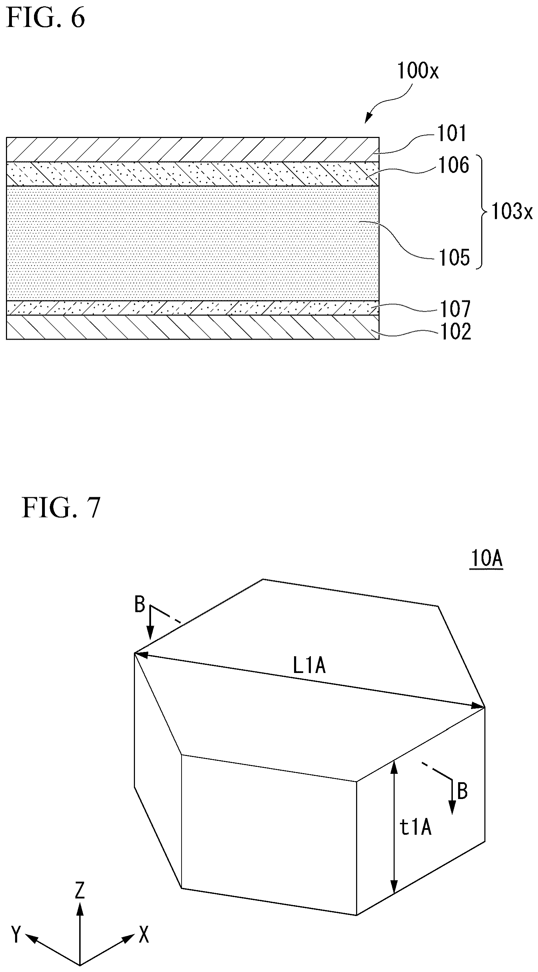

The photoelectric conversion element is not limited to the above configuration. FIG. 6 is a sectional view of a modification example 100x of a photoelectric conversion element including the upconverting particles 10 in FIG. 1. The photoelectric conversion element 100x is constituted by a positive electrode layer (positive electrode member) 101, a negative electrode layer (negative electrode member) 102, and a photoelectric conversion layer 103x sandwiched therebetween. The photoelectric conversion layer 103x includes a layered second layer 105 and a layered third layer 106. Similarly to the photoelectric conversion element 100x, the second layer 105 and the third layer 106 may be formed in a uniform film shape.

### (Method of manufacturing photoelectric conversion element 100)

A method of manufacturing the photoelectric conversion element 100 is not particularly limited. The photoelectric conversion element 100 can be manufactured by forming each layer using a known method such as a vacuum vapor deposition method, a spin coating method, or a dipping method.

The upconverting particle 10 according to the first embodiment, the core portion 11(that is, the upconverting micro precursor particle to serve as the central particle) contained in the upconverting particle 10 according to the first embodiment, and the photoelectric conversion element 100 have been described above. The upconverting particle 10 has a hexagonal columnar particle shape, a particle diameter of equal to or greater than 300 nm, a thickness of equal to or greater than 100 nm, and an aspect ratio as the particle diameter/the thickness of equal to or greater than 1.2 and equal to or less than 5.0 and thus has high upconverting light emission efficiency. Therefore, the photoelectric conversion element 100 using the upconverting particle 10 has a high photoelectric conversion characteristic.

Also, the core portion 11 has a hexagonal columnar particle shape, a particle diameter of equal to or greater than 300 nm, a thickness of equal to or greater than 100 nm, and an aspect ratio as the particle diameter/the thickness of equal to or greater than 1.2 and equal to or less than 5.0 and thus has high upconverting light emission efficiency. Therefore, the upconverting particle 10 including the core portion 11 has high upconverting light emission efficiency.

### <Second embodiment>

### (Upconverting particle 10A)

FIG. 7 is a schematic diagram of an upconverting particle 10A according to an embodiment of the present invention. FIG. 8 is a schematic sectional view of the upconverting particle 10A in FIG. 7 taken along the line B-B. The upconverting particle 10A includes a core portion (central particle) 11A and a shell portion (coating layer) 12A that covers the core portion 11A. The upconverting particle 10A of the present disclosure is a particle that has a core-shell structure. The particle shape of the upconverting particle 10A is a hexagonal columnar shape.

### "Particle diameter of upconverting particle 10A"

A particle diameter L1A of the upconverting particle 10A is equal to or greater than 300 nm. The particle diameter L1A of the upconverting particle 10A is preferably equal to or greater than 500 nm. A more preferable particle diameter L1A of the upconverting particle 10A is equal to or greater than 550 nm. A particularly preferable particle diameter L1 of the upconverting particle 10 is equal to or greater than 600 nm. The particle diameter L1A of the upconverting particle 10A is preferably equal to or less than 2000 nm. A more preferable particle diameter L1 of the upconverting particle 10A is equal to or less than 1500 nm. Here, the particle diameter L1A of the upconverting particle 10A is a diameter of a minimum enclosing circle that encloses the hexagonal shape of a bottom surface of the upconverting particle 10.

### "Thickness of upconverting particle 10A"

A thickness t1A of the upconverting particle 10A is equal to or greater than 100 nm. Amore preferable thickness t1A of the upconverting particle 10 is equal to or greater than 300 nm. A thickness t1A of the upconverting particle 10 is equal to or less than 600 nm. Here, the thickness t1A of the upconverting particle 10 is the length of the hexagonal column in the thickness direction.

### "Particle diameter L1A of upconverting particle 10A/thickness t1A of upconverting particle 10A"

An aspect ratio as the particle diameter of the upconverting particle 10A/the thickness of the upconverting particle 10A is equal to or greater than 1.2 and equal to or less than 5.0. The particle diameter L1A of the upconverting particle 10A/the thickness t1A of the upconverting particle 10A is preferably equal to or greater than 1.5. It is possible to increase luminance of visible light or ultraviolet light after conversion of light with a long wavelength by the aspect ratio as the particle diameter L1A of the upconverting particle 10A/the thickness t1A of the upconverting particle 10A being equal to or greater than 1.2 and equal to or less than 5.0. The particle diameter and the thickness of the upconverting particle 10A can be measured by the same method as that for the upconverting particle 10.

### "Core portion 11A"

The core portion 11A is a particle serving as a core (an upconverting micro precursor particle serving as a central particle) of the upconverting particle (core-shell type particle) 10A.

The core portion 11A contains, for example, at least one of a metal which is a rare earth element capable of emitting excitation light in the visible or ultraviolet region, such as erbium (Er), thulium (Tm), ytterbium (Yb), neodymium (Nd), holmium (Ho), praseodymium (Pr), gadolinium (Gd), europium (Eu), terbium (Tb), samarium (Sm), cerium (Ce), or dysprosium (Dy), or compounds thereof. Examples of the core portion 11A include inorganic fine particles such as NaErF₄, Tm₂O₃, TmCl₃, TmF₃, Er₂O₃, ErCl₃, ErF₃, Ho₂O₃, HoCl₃, and HoF₃, and inorganic fine particles containing rare earth atoms (hereinafter, referred to as first doped rare earth atoms in some cases) doped as guests in a crystal lattice as a host. As the core portion 11A, an inorganic fine particle containing the first doped rare earth atoms as guests in the crystal lattice as a host is preferably adopted. As the core portion 11A, it is possible to improve efficiency of upconverting light emission by adopting the inorganic fine particle containing the first doped rare earth atoms as guests in the crystal lattice as a host.

In a case where the core portion 11A is an inorganic fine particle containing doped rare earth atoms as guests in the crystal lattice as a host, examples of the crystal lattice as a host of the core portion 11 include NaYF₄ and Gd₂O₂S. As the crystal lattice as a host of the core portion 11, NaYF₄ is preferably adopted, for example. The crystal lattice of the core portion 11A is preferably a dielectric body.

In a case where the core portion 11A is an inorganic fine particle containing doped rare earth atoms as guests in the crystal lattice as the host, examples of the first doped rare earth elements include rare earth elements capable of emitting excitation light in the visible or ultraviolet region, such as erbium (Er), thulium (Tm), ytterbium (Yb), neodymium (Nd), holmium (Ho), praseodymium (Pr), gadolinium (Gd), europium (Eu), terbium (Tb), samarium (Sm), cerium (Ce), and dysprosium (Dy). The total content of the first doped rare earth atoms is preferably 0.5% by mass to 40% by mass with respect to the total mass of the core portion 11A. It is possible to suppress collapse of the crystal structure and to improve efficiency of upconverting light emission by the total content of the first doped rare earth atoms being 0.5% by mass to 40% by mass with respect to the total mass of the core portion 11A.

The core portion 11A preferably contains both the light-absorbing sensitizing atoms and the light-emitting activating atoms as the first doped rare earth atoms. The light-absorbing sensitizing atoms are, for example, one or more kinds selected from the group consisting of Yb and Nd. The light-absorbing sensitizing atoms are, for example, both Yb or both Yb and Nd atoms. The light-emitting activating atoms are, for example, one or more kinds selected from the group consisting of Tm, Er, and Ho. Examples of the core portion 11A include inorganic fine particles composed of Gd₂O₂S (that is, "Gd₂O₂S: Er, Yb") doped with Yb and Er, NaYF₄ (that is, "NaYF₄: Er, Yb") doped with Yb³⁺ and Er³⁺, NaYF₄ (that is, "NaYF₄: Tm, Yb") doped with Tm and Yb, and NaYF₄ (that is, "NaYF₄: Nd, Yb") doped with Nd and Yb. It is particularly preferable that the crystal lattice as a host of the core portion 11A be NaYF₄, both light-absorbing sensitizing atoms and light-emitting activating atoms be contained as guests, the light-absorbing sensitizing atoms be Yb or both Yb and Nd atoms, and the light-emitting activating atoms be one or more kinds selected from the group consisting of Tm, Er, and Ho. The core portion 11A preferably contains Nd as a first doped rare earth atom.

In a case where the core portion 11A contains both light-absorbing sensitizing atoms and light-emitting activating atoms as the first doped rare earth atoms, the doped rare earth atoms contained as guests in the core portion 11A are preferably a pair of either both Nd and Yb atoms or both Tm and Yb atoms. In other words, the core portion 11A preferably contains both the Nd and Yb atoms as guests, or the core portion 11A preferably contains both Tm and Yb atoms as guests. In a case where both Tm and Yb atoms are contained as doped rare earth atoms in the core portion, the molar ratio of Tm and Yb is preferably 10:30 to 30:10. More preferably, the molar ratio of Tm and Yb is 15:25 to 25:15. In a case where Nd and Yb are contained as doped rare earth atoms in the core portion, the molar ratio of Nd and Yb is preferably 10:30 to 30:10. More preferably, the molar ratio of Nd and Yb is 15:25 to 25:15.

A particle diameter (diameter length) C1A of the core portion 11A is preferably 500 nm to 1500 nm. The particle diameter C1A of the core portion 11A is a diameter of a minimum enclosing circle enclosing the hexagonal shape in a plane perpendicular to the height direction of the hexagonal column.

### (Shell portion 12A)

The shell portion 12 is a covering layer that covers the core portion 11A. Examples of the material of the shell portion 12A include materials containing at least one of metals which are rare earth elements capable of emitting excitation light in the visible or ultraviolet region, such as erbium (Er), thulium (Tm), ytterbium (Yb), neodymium (Nd), holmium (Ho), praseodymium (Pr), gadolinium (Gd), europium (Eu), terbium (Tb), samarium (Sm), cerium (Ce), or dysprosium (Dy), or compounds thereof. Examples of the shell portion 12A include coating layers containing inorganic fine particles such as NaErF₄, Tm₂O₃, TmCl₃, TmF₃, Er₂O₃, ErCl₃, ErF₃, Ho₂O₃, HoCl₃, and HoF₃, and rare earth atoms (hereinafter, referred to as second doped rare earth atoms in some cases) doped as guests in the crystal lattice as a host. As the shell portion 12A, a coating layer containing the second doped rare earth atoms as guests in the crystal lattice as a host is preferably adopted. The rare earth atoms (for example, the second doped rare earth atoms) contained in the shell portion 12A are different from the rare earth atoms (for example, the first doped rare earth atoms) contained in the core portion 11A. Energy transfer becomes more likely to occur, and upconverting light emitting characteristics are improved by the rare earth atoms (for example, the second doped rare earth atoms) contained in the shell portion 12A being different from the rare earth atoms (for example, the first doped rare earth atoms) contained in the core portion 11A. The shell portion 12A preferably causes energy transfer with the core portion 11A. Specifically, energy transfer preferably occurs between the second doped rare earth atoms of the shell portion 12A and the first doped rare earth atoms of the core portion 11A.

In a case where the shell portion 12A is a covering layer containing the second doped rare earth atoms as guests in a crystal lattice as a host, examples of the crystal lattice as the host of the shell portion 12A include simple oxides such as CeO₃ and Y₂O₃, complex halides such as NaYF₄, and complex oxides such as Gd₂O₂S, CaAl₁₂O₁₉, YTa₇O₁₉, GdTa₇O₁₉, and MTa₇O₁₁ (M=Ca, Sr, Ba). The crystal lattice of the shell portion 12A is preferably a dielectric body. As the crystal lattice as the host of the shell portion 12A, a composite halide having low phonon energy such as NaYF₄ and capable of suppressing a loss of excitation energy due to non-radiative transition that inactivates energy to heat without emitting light in an excited state, for example, is preferably adopted.

In a case where the shell portion 12A is a covering layer containing the second doped rare earth atoms as guests in the crystal lattice as the host, examples of the second doped rare earth elements include rare earth elements capable of emitting excitation light in the visible or ultraviolet region, such as erbium (Er), thulium (Tm), ytterbium (Yb), neodymium (Nd), holmium (Ho), praseodymium (Pr), gadolinium (Gd), europium (Eu), terbium (Tb), samarium (Sm), cerium (Ce), and dysprosium (Dy). The total content of the second doped rare earth atoms is preferably 0.5% by mass to 40% by mass with respect to the total mass of the shell portion 12A.

The shell portion 12A preferably contains both the light-absorbing sensitizing atoms and the light-emitting activating atoms as the second doped rare earth atoms. The light-absorbing sensitizing atoms are, for example, one or more kinds selected from the group consisting of Yb and Nd. The light-absorbing sensitizing atoms are, for example, both Yb or both Yb and Nd atoms. The light-absorbing sensitizing atoms are, for example, one or more kinds selected from the group consisting of Tm, Er, and Ho. Examples of such a shell portion 12A include inorganic layers composed of NaYF₄ (that is, "NaYF₄: Er, Yb") doped with Yb³⁺ and Er³⁺, NaYF₄ (that is, "NaYF₄: Tm, Yb") doped with Tm³⁺ and Yb³⁺, and NaYF₄ (that is, "NaYF₄: Nd, Yb") doped with Nd³⁺ and Yb³⁺. It is particularly preferable that the crystal lattice as a host of the shell portion 12A be NaYF₄, both light-absorbing sensitizing atoms and light-emitting activating atoms be contained as guests, the light-absorbing sensitizing atoms be Yb or both Yb and Nd atoms, and the light-emitting activating atoms be one or more kinds selected from the group consisting of Tm, Er, and Ho. The shell portion 12A preferably contains Nd as a second doped rare earth atom.

In a case where the shell portion 12A contains both light-absorbing sensitizing atoms and light-emitting activating atoms as the second doped rare earth atoms, the second doped rare earth atoms contained as guests in the shell portion 12A are preferably a pair of either both Nd and Yb atoms or both Tm and Yb atoms. In other words, the shell portion 12A preferably contains both the Nd and Yb atoms as guests, or the shell portion 12A preferably contains both Tm and Yb atoms as guests. In a case where both Tm and Yb atoms are contained as the second doped rare earth atoms in the shell portion 12A, the molar ratio of Tm and Yb is preferably 10:30 to 30:10. More preferably, the molar ratio of Tm and Yb is 15:25 to 25:15. In a case where Nd and Yb are contained as the second doped rare earth atoms in the shell portion 12A, the molar ratio of Nd and Yb is preferably 10:30 to 30:10. More preferably, the molar ratio of Nd and Yb is 15:25 to 25:15.

A thickness (width) ShlA of the shell portion 12A is preferably 100 nm to 500 nm, for example. Note that since a shell/core ratio, which is a ratio of the width of the shell portion/the diameter length of the core portion of the upconverting particle 10, is preferably equal to or greater than 0.01 and equal to or less than 10.00 as will be described later, it is also possible to set the thickness (width) ShlA of the shell portion 12 to be smaller than a lower limit value of the aforementioned preferable range in accordance with the particle diameter (diameter length) C1 of the core portion 11 in a case where the shell/core ratio is 0.01, for example. Specifically, the thickness (width) Sh1A of the shell portion 12 may be 5 nm when the particle diameter (diameter length) C1 of the core portion 11 is 500 nm, and the thickness (width) ShlA of the shell portion 12 may be 1 nm when the particle diameter (diameter length) C1 is 100 nm, for example.

The thickness (width) Sh1A of the shell portion 12A is a length of the shell portion 12A in a direction perpendicular to the interface between the core portion 11A and the shell portion 12 in a plane perpendicular to the height direction of the hexagonal column.

The coverage of the shell portion 12A with respect to the surface of the core portion 11A is preferably equal to or greater than 50%. The coverage of the shell portion 12A with respect to the surface of the core portion 11A is preferably 100%.

The shell portion 12A may include a single layer or two or more layers. Even if long-chain organic molecules used as a gelling agent remain on or adhere to and are present on the surface of the particle at the time of the manufacturing of the upconverting particle 10, specifically, after crystal growth by a heating operation in the sol-gel method, for example, it is possible to separate the long-chain organic molecules from the core portion 11 and to suppress vibration deactivation due to the long-chain organic molecules by increasing the number of layers. Light emission efficiency of the upconverting particle 10A can thus be improved. In a case where the shell portion 12Ahas a plurality of layers, for example, the outermost layer of the shell portion 12A may be NaNdF₄ or NaYF₄. In this manner, effects of sensitizing light absorption and suppressing energy deactivation can be obtained. Additionally, even if the shell portion 12 includes two or more layers in terms of a manufacturing process, for example, in a case where a first shell layer and a second shell layer have the same composition and both the first shell layer and the second shell layer are integrated to form a shell layer without having a clear interface therebetween, the first shell layer and the second shell layer can be regarded as a single layer together. Such a case is, for example, a case where presence of an interface between the first shell layer and the second shell layer cannot be observed even using observation with an electron microscope.

### (Shell/core ratio, which is width of shell portion 12/diameter length of core portion 11 of upconverting particle 10A)

The shell/core ratio, which is the width of the shell portion/the diameter length of the core portion of the upconverting particle 10A, is preferably equal to or greater than 0.01 and equal to or less than 10.00. A more preferable shell/core ratio is equal to or greater than 0.10 and equal to or less than 2.00.

### (Relationship between first doped rare earth atoms contained in core portion 11 and second doped rare earth atoms contained in shell portion 12A)

In order to cause energy transfer from the first doped rare earth atoms to the second doped rare earth atoms, a first energy level that is an energy level of the first doped rare earth atoms is preferably different from a second energy level that is an energy level of the second doped rare earth atoms. Specifically, in a case where the second doped rare earth atoms emit light, the first energy level (the first energy level after excitation), which is an energy level of the first doped rare earth atoms in an excited state after excitation through external energy irradiation of infrared light or the like, is preferably higher than the second energy level (the light emission second energy level), which is an energy level received by the second doped rare earth atoms for light emission, in order to cause energy transfer from the first doped rare earth atoms to the second doped rare earth atoms. In a case where the first doped rare earth atoms emit light, the second energy level (the second energy level after excitation), which is an energy level of the second doped rare earth atoms in an excited state after excitation through external energy irradiation of infrared light or the like, is preferably higher than the first energy level (the light emission first energy level), which is an energy level received by the first doped rare earth atoms for light emission, in order to cause energy transfer from the second doped rare earth atoms to the first doped rare earth atoms. It is possible to improve upconverting light emission efficiency by energy transfer (energy migration) occurring in this manner.

It is preferable that third doped rare earth atoms which are doped rare earth atoms that are different from the first doped rare earth atoms and the second doped rare earth atoms are further present as guests of at least one of the core portion 11A and the shell portion 12A. It is preferable that a third energy level, which is an energy level of the third doped rare earth atoms, be located between the energy level of the first doped rare earth atoms and the energy level of the second doped rare earth atoms.

Specifically, in a case where the core portion 11A or the shell portion 12A contains the third doped rare earth atoms and the second doped rare earth atoms emit light, it is preferable that the first energy level (the first energy level after excitation), which is an energy level of the first doped rare earth atoms in an excited state after excitation through external energy irradiation of infrared light or the like be higher than the second energy level (the light emission second energy level), which is an energy level received by the second doped rare earth atoms for light emission and the third energy level, which is an energy level of the third doped rare earth atoms to mediate energy migration (third energy level) be located between the energy level (the first energy level after excitation) of the first doped rare earth atoms and the energy level (the light emission second energy level) of the second doped rare earth atoms in order to cause energy transfer from the first doped rare earth atoms to the second doped rare earth atoms. When an energy difference between the first energy level after excitation and the third energy level is 0.3 eV and an energy difference between the third energy level and the light emission second energy level is equal to or less than 0.3 eV, energy mitigation occurs and more efficient light emission becomes possible.

In a case where the core portion 11A or the shell portion 12A contains the third doped rare earth atoms and the first doped rare earth atoms emit light, it is preferable that the second energy level (the second energy level after excitation), which is an energy level of the second doped rare earth atoms in an excited state after excitation through external energy irradiation of infrared light or the like be higher than the first energy level (the light emission first energy level), which is an energy level received by the first doped rare earth atoms for light emission and the third energy level, which is an energy level of the third doped rare earth atoms to mediate energy migration be located between the energy level (the light emission first energy level) of the first doped rare earth atoms and the energy level (the second energy level after excitation) of the second doped rare earth atoms in order to cause energy transfer from the second doped rare earth atoms to the first doped rare earth atoms. When an energy difference between the second energy level after excitation and the third energy level is 0.3 eV and an energy difference between the third energy level and the light emission first energy level is equal to or less than 0.3 eV, energy mitigation occurs and more efficient light emission becomes possible.

It is preferable that the first doped rare earth atoms of the core portion 11A be a pair of either both Nd and Yb atoms or both Tm and Yb atoms and the second doped rare earth atoms of the shell portion 12A be a pair of both Nd and Yb atoms or both Tm and Yb atoms, which is a pair different from the first doped rare earth atoms. Specifically, in a case where the first doped rare earth atoms of the core portion 11A are Nd and Yb, the second doped rare earth atoms of the shell portion 12A are Tm and Yb. In other words, the core portion 11A contains both Nd and Yb atoms, and the shell portion 12A contains both Tm and Yb atoms in this case. In a case where the first doped rare earth atoms of the core portion 11A are Tm and Yb, the second doped rare earth atoms of the shell portion 12A are Nd and Yb. In other words, the core portion 11A contains both Tm and Yb atoms, and the shell portion 12A contains both Nd and Yb atoms in this case. Note that in the specification, the upconverting particle covered with TiO₂ coating may be referred to as a TiO₂-coated core-shell type upconverting particle.

Upconverting light emission in a case where the first doped rare earth atoms of the core portion 11A are a pair of either both Nd and Yb atoms or both Tm and Yb atoms and the second doped rare earth atoms of the shell portion 12A are a pair of both Nd and Yb atoms or both Tm and Yb atoms, which is a pair different from that of the first doped rare earth atoms, will be described. Nd in the core portion 11A or the shell portion 12A is excited when irradiated with light from the outside. Energy transfer occurs from Nd after the excitement to Yb contained in the core portion 11A and the shell portion 12A. Next, energy transfer occurs from Yb to Tm. Upconverting light emission to ultraviolet light is enabled by Tm that has received the energy emitting ultraviolet light. In this case, energy transfer occurs from ²H_{9/2} of Nd to ²F_{5/2} of Yb, and energy transfer occurs from ²F_{5/2} of Yb to ³H₅ of Tm, thereby causing the ultraviolet light emission.

In a case where the second doped rare earth atoms emit light, it is preferable that the second doped rare earth atoms have a plurality of energy levels after excitation (the second energy level after the excitation) at positions higher than an energy level before excitation (the second energy level before the excitation) at which the second doped rare earth atoms receive energy transferred from the first doped rare earth atoms or the third doped rare earth atoms, and that an energy gap (that is, transition energy) between the energy level before the excitation and one of the energy levels after the excitation be equal to the transferred energy.

In a case where the first doped rare earth atoms emit light, it is preferable that the first doped rare earth atoms have a plurality of energy levels after excitation (the first energy level after the excitation) at positions higher than an energy level before excitation (the first energy level before the excitation) at which the first doped rare earth atoms receive energy transferred from the second doped rare earth atoms or the third doped rare earth atoms, and that an energy gap (that is, transition energy) between the energy level before the excitation and one of the energy levels after the excitation be equal to the transferred energy.

Note that the above description has been given on the assumption that the first doped rare earth atoms are a pair of Nd and Yb or a pair of Tm and Yb while the second doped rare earth atoms are a pair of Nd and Yb or a pair of Tm and Yb, which is a pair different from the pair of the first doped rare earth atoms. The upconverting particles 10A described above can also be understood as upconverting particles 10A in which the core portion 11A contains Nd or Tm as a first rare earth atom and contains Yb as a third rare earth atom while the shell portion 12A contains an atom different from the first rare earth atom out of Nd or Tm as a second rare earth atom and contains Yb as a third rare earth atom.

### (Method of manufacturing upconverting particle 10A)

Next, a method of manufacturing the upconverting particle 10A according to the present disclosure will be described. As illustrated in FIG. 9, the method of manufacturing the upconverting particle 10A according to the present disclosure includes: a first step S1 of forming the core portion 11A by causing a crystal to grow under a condition of a range of 50°C to 500°C by a sol-gel method; and a second step S2A of causing a crystal constituting the shell portion 12 to grow on a surface of the core portion 11A after the first step S1 by a sol-gel method under a condition of a range of 50°C to 500°C.

### "First step S1"

In the first step S1, the core portion 11 is formed through crystal growth by the sol-gel method under a condition of a range of 50°C to 500°C.

Specifically, a trifluoroacetate is synthesized using a rare earth atom oxide such as Y₂O₃, Er₂O₃, Nd₂O₃, Tm₂O₃, Ho₂O₃, or Yb₂O₃, or a rare earth atom halide such as YCl₃, ErCl₃, ErF₃, TmCl₃, TmF₃, HoCl₃, or HoF₃, for example, as a main raw material. The ratio of each material is determined in accordance with the intended composition ratio. Furthermore, sodium trifluoroacetate and an organic molecule having 1 to 3 long-chain hydrocarbon groups having about 8 to 24 carbon atoms, such as 1-octadecene, an oleic acid, oleylamine, trioctylphosphine oxide, a linoleic acid, or octylamine, or a long-chain organic molecule such as a carboxylic acid thereof, for example, are used as a gelling agent, and a reaction is caused in an N₂ or Ar atmosphere at a low temperature condition (50°C to 500°C). The solution after the reaction is cooled, an organic solvent such as ethanol is added as necessary, and the central particle as the core portion 11 is then separated by centrifugation. A main row material of the core portion 11 is appropriately adjusted to include a crystal lattice as a host and doped rare earth atoms as guests. In a case where the crystal lattice as a host is NaYF₄ and the doped rare earth atoms are Nd and Yb, for example, Y₂O₃, Nd₂O₃, and Yb₂O₂ are selected, and the ratio thereof is determined in accordance with the composition ratio of the core portion 11 to be obtained.

The crystal growth in the first step S1 is performed by a heating operation including (a) formation of an α phase (cubic crystal) and (b) phase transition from the α phase (cubic crystal) to a β phase (hexagonal crystal). For example, the heating operation for forming the α phase is performed by raising the temperature from an ordinary temperature to a temperature range (first temperature range) of 80°C to 150°C at a temperature raising speed of about 100°C/4 minutes to 100°C/10 minutes and performing heating processing in the first temperature range for about 10 minutes to 40 minutes. The heating operation for the phase transition from the α phase to the β phase is performed by raising the temperature from the first temperature range to a temperature range of 200°C to 500°C (second temperature range) at a temperature raising speed of about 100°C to 300°C/about 10 minutes to 15 minutes and performing heating processing in the second temperature range for 20 minutes to 80 minutes. Only the β phase can be obtained by performing the heating processing in the second temperature range for 60 minutes or more.

The aforementioned heating operation in the first step S1 is preferably performed until the integrated temperature as a heating condition for the phase transition from the α phase to the β phase exceeds the integrated temperature as a heating condition for the formation of the cubic crystal. This facilitates formation of the upconverting particle 10A having a particle diameter of equal to or greater than 500 nm, a thickness of equal to or greater than 300 nm, and an aspect ratio as the particle diameter/the thickness of equal to or greater than 1.2 and equal to or less than 3.0.

The heating operation in the first step S1 is performed with a degassing operation for maintaining a preset degree of vacuum. The degree of vacuum is, for example, 0.1 Pa to 0.01 Pa. This facilitates formation of the upconverting particle 10A having a particle diameter of equal to or greater than 500 nm, a thickness of equal to or greater than 300 nm, and an aspect ratio as the particle diameter/the thickness of equal to or greater than 1.2 and equal to or less than 3.0.

### "Second step S2A"

Next, in the second step S2A, a crystal constituting the shell portion 12 is caused to grow on the surface of the core portion 11A formed in the first step S1 by the sol-gel method under a condition of a range of 50°C to 500°C. A trifluoroacetate is synthesized similarly to the first step by selecting a rare earth atom oxide or a rare earth atom halide such that a component of the crystal lattice constituting the shell portion 12A is the same component as that of the crystal lattice as a host of the aforementioned core portion 11, and the second doped rare earth atom as a guest is different therefrom. The main raw material of the shell portion 12A is appropriately adjusted so as to contain a crystal lattice as a host and the second doped rare earth atom as a guest. The second doped rare earth atom is adjusted so as to be different from the first rare earth atom of the core portion 11A. For example, in a case where the crystal lattice as a host of the core portion 11A is NaYF₄, the first doped rare earth atoms are Nd and Yb, the crystal lattice as a host of the shell portion 12A is NaYF₄, and the doped rare earth atoms are Tm and Yb, Y₂O₃, Tm₂O₂, and Yb₂O₂ are selected, and the ratio thereof is determined in accordance with a desired composition ratio of the shell portion 12A. Next, the core portion 11 obtained in the first step S1, sodium trifluoroacetate, and an organic molecule having 1 to 3 long-chain hydrocarbon groups having about 8 to 24 carbon atoms, such as 1-octadecene, an oleic acid, oleylamine, trioctylphosphine oxide, a linoleic acid, or octylamine, or a long-chain organic molecule such as a carboxylic acid thereof, for example, are used as a gelling agent, and a reaction is caused in an N₂ or Ar atmosphere under a low temperature condition (50°C to 500°C). The solution after the reaction is cooled, an organic solvent such as ethanol is added as necessary, and the upconverting particle 10A is then separated by centrifugation. In a case where the shell portion 12A including a plurality of layers is formed around the core portion 11, the upconverting particle 10A including a plurality of layers can be obtained by repeating the above steps. It is preferable that the crystal lattice of the core portion 11A formed in the first step S1 and the crystal lattice of the shell portion 12A formed in the second step S2A are made of the same component and the second doped rare earth atoms of the shell portion 12A be different from the first doped rare earth atoms of the core portion 11A.

### (Photoelectric conversion element)

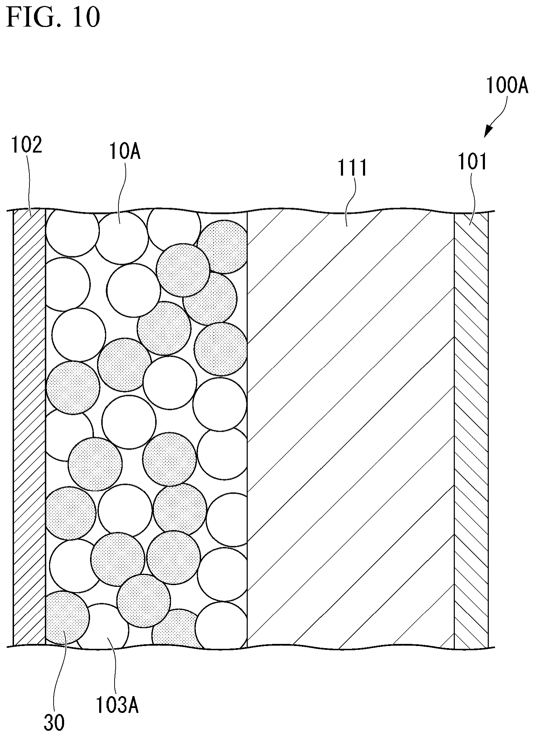

In the following description, a case where the upconverting particle 10A emits ultraviolet light will be described as an example. FIG. 10 is a sectional view of the photoelectric conversion element 100A including the upconverting particle 10A. The photoelectric conversion element 100 is configured mainly of a positive electrode layer (positive electrode member) 101, a negative electrode layer (negative electrode member) 102, a photoelectric conversion layer 103A sandwiched therebetween, and an intermediate layer 111 sandwiched between the photoelectric conversion layer 103A and the positive electrode layer 101.

### "Negative electrode layer 102"

In order to take light into the photoelectric conversion layer 103, the negative electrode layer 102 is preferably constituted by a light-transmitting material with light transmittance, for example, a transparent conductive film such as antimony-doped indium oxide (ATO), indium tin oxide (ITO), zinc oxide, tin oxide, or fluorine-doped indium oxide (FTO). As the negative electrode layer 102, ATO having heat resistance is preferable.

### "Positive electrode layer 101"

The positive electrode layer 101 may not be transparent, and metal, a conductive polymer, or the like can be used as an electrode material of the electrode. Specific examples of the electrode material include metal such as gold (Au), silver (Ag), aluminum (Al), zinc (Zn), and platinum (Pt), alloys of two or more thereof, graphite, a graphite interlayer compound, polyaniline and derivatives thereof, and polythiophene and derivatives thereof. The positive electrode layer 101 is preferably Pt (particularly, in a case where the electrolyte is a solution), or Au or Ag (particularly, in a case where the electrolyte is a solid).

### "Photoelectric conversion layer 103A"

As illustrated in FIG. 10, the photoelectric conversion layer 103A includes a TiO₂ layer containing the upconverting particles 10A in the photoelectric conversion layer 103A. The photoelectric conversion element 100A according to the second embodiment includes the photoelectric conversion layer 103A containing inorganic semiconductor particles 30 made of TiO₂ and upconverting particles 10A.

The content of the upconverting particles 10A is preferably 10% by mass to 90% by mass with respect to the total mass of the photoelectric conversion layer 103A. The photoelectric conversion characteristic of the photoelectric conversion element 100A is improved by the content of the upconverting particles 10A being 10% by mass to 90% by mass with respect to the total mass of the photoelectric conversion layer 103A.

The content of the inorganic semiconductor particles 30 is preferably 10% by mass to 90% by mass with respect to the total mass of the photoelectric conversion layer 103A. The photoelectric conversion characteristic of the photoelectric conversion element 100A is improved by the content of the inorganic semiconductor particles 30 being 10% by mass to 90% by mass with respect to the total mass of the photoelectric conversion layer 103A. The average particle diameter of the inorganic semiconductor particles 30 is 10 nm to 1000 nm.

The total of the upconverting particles 10A and the inorganic semiconductor particles 30 is 90% by mass to 100% by mass. The photoelectric conversion layer 103A may contain a material such as a binder in addition to the upconverting particles 10A and the inorganic semiconductor particles 30.

Although a larger number of current paths to be formed in the photoelectric conversion layer 103A is better, adjacent current paths may be electrically connected to each other or may not be connected to each other. Note that the "layer" in the present embodiment means a film formed in one or a plurality of film forming processes, is not limited to a flat film, and may not be integrated.

### "Intermediate layer 111"

The intermediate layer 111 is disposed between the photoelectric conversion layer 103A and the positive electrode layer 101. The intermediate layer is, for example, an electrolyte or a hole transport layer. In the case of the electrolyte layer, the material of the intermediate layer 111 is iodine. As the hole transport layer, the material of the intermediate layer 111 is Spiro-OMeTAD or a triphenylamine derivative. Due to presence of the intermediate layer 111, effects contributing to an increase in efficiency of photoelectric conversion and an increase in lifetime of the photoelectric conversion element are obtained.

The upconverting particle 10A according to the second embodiment, the core portion 11A (that is, the upconverting micro precursor particle serving as a central particle) included in the upconverting particle 10A according to the second embodiment, and the photoelectric conversion element 100A have been described above. The upconverting particle 10A has a hexagonal columnar particle shape, a particle diameter of equal to or greater than 300 nm, a thickness of equal to or greater than 100 nm, an aspect ratio as the particle diameter/the thickness of equal to or greater than 1.2 and equal to or less than 5.0, and thus has high upconverting light emission efficiency. Therefore, the photoelectric conversion element 100A using the upconverting particle 10 has a high photoelectric conversion characteristic.

Also, the core portion 11A has a hexagonal columnar particle shape, a particle diameter of equal to or greater than 300 nm, a thickness of equal to or greater than 100 nm, and an aspect ratio as the particle diameter/the thickness of equal to or greater than 1.2 and equal to or less than 5.0 and thus has high light emission quantum yield. Therefore, the upconverting particle 10A including the core portion 11A has high upconverting light emission efficiency.

In a case where the photoelectric conversion element 100A is irradiated with near-infrared light, the upconverting particle 10A emits ultraviolet light. This ultraviolet light is absorbed by TiO₂, and electromotive force is generated. In the photoelectric conversion element 100A, it is possible to cause the inorganic semiconductor (TiO₂) to perform direct absorption without dye sensitization or the like by using the upconverting particle 10A. Therefore, an excellent photoelectric conversion characteristic is exhibited.

### <Third embodiment>

### (Upconverting particle 10B)

Hereinafter, an upconverting particle 10B according to a third embodiment will be described. In the upconverting particle 10B, a TiO₂ layer is further provided on the surface of the shell layer 12A of the upconverting particle 10A according to the second embodiment. The same elements as those of the upconverting particle 10A will be denoted by the same reference numbers, and description thereof will be omitted.

FIG. 11 is a schematic diagram of the upconverting particle 10B according to an embodiment of the present invention. FIG. 12 is a schematic sectional view of the upconverting particle 10B taken along the line C-C in FIG. 11.

The upconverting particle 10B includes a core portion (an upconverting micro precursor particle serving as a central particle) 11B, a shell portion (coating layer) 12B that covers the core portion 11B, and a TiO₂ layer 13 that covers the shell portion 12B. The upconverting particle 10B of the present disclosure is a particle that has a core-shell structure. The particle shape of the upconverting particle 10B is a hexagonal columnar shape. The upconverting particle 10A is an upconverting particle that performs upconverting light emission with ultraviolet light.

### "TiO₂ layer"

The TiO₂ layer 13 is a layer made of TiO₂. Light emitted from the core portion 11A or the shell portion 12A is absorbed by the TiO₂ layer 13. This enables direct photoelectric conversion.

The thickness T1B of the TiO₂ layer 13 is, for example, 1 nm to 100 nm.

The coverage of the TiO₂ layer 13 with respect to the surface of the shell portion 12A is preferably equal to or greater than 50%. The coverage of the TiO₂ layer 13 with respect to the surface of the shell portion 12A is more preferably 100%.

### (Method of manufacturing upconverting particle 10B)

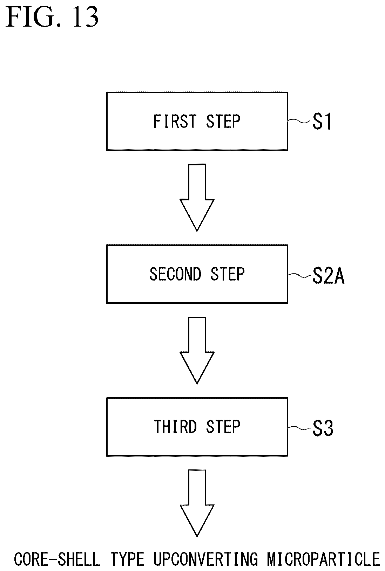

Next, a method of manufacturing the upconverting particle 10B according to the present disclosure will be described. As illustrated in FIG. 13, the method of manufacturing the upconverting particle 10B according to the present disclosure includes: a first step S1 of forming the core portion 11A by causing a crystal to grow under a condition of a range of 50°C to 500°C by a sol-gel method; a second step S2A of causing a crystal constituting the shell portion 12 to grow on a surface of the core portion 11A after the first step S1 by a sol-gel method under a condition of a range of 50°C to 500°C; and a third step S3 of forming the TiO₂ layer 13 on the surface of the shell portion 12A. The same steps as those of the method of manufacturing the upconverting particle 10A will be denoted by the same reference numbers, and description thereof will be omitted.

### "Third step S3"

In the third step S3, the TiO₂ layer 13 is formed on the surface of the shell portion 12A. A method for forming the TiO₂ layer 13 on the surface of the shell portion 12A is not particularly limited. For example, the TiO₂ layer 13 may be formed by causing a reaction with a Ti compound (for example, titanium diisopropoxide bis (acetylacetonate) ([(CH₃)₂CHO]₂Ti(C₅H₇O₂)₂) or titanium chloride (TiCl₄) under a predetermined temperature condition (for example, at 70°C for 60 minutes) and then sintering the Ti compound at 450°C for 1 hour, with respect to the upconverting particle 10A according to the second embodiment.

### (Photoelectric conversion element)

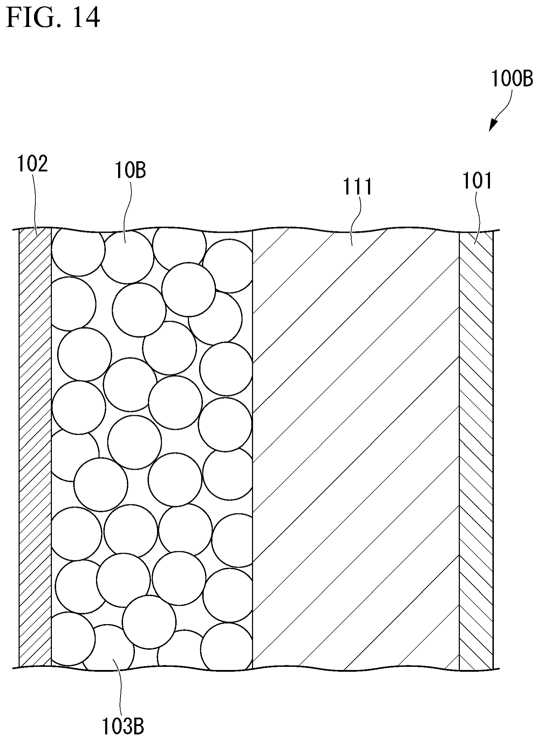

In the following description, a case where the upconverting particle 10B emits ultraviolet light will be described as an example. FIG. 14 is a sectional view of the photoelectric conversion element 100B including the upconverting particles 10B. The photoelectric conversion element 100 is configured mainly of a positive electrode layer (positive electrode member) 101, a negative electrode layer (negative electrode member) 102, a photoelectric conversion layer 103B sandwiched therebetween, and an intermediate layer 111 sandwiched between the photoelectric conversion layer 103A and the positive electrode layer 101. Elements having the same functions as those of the photoelectric conversion layer 103A are denoted by the same reference numbers, and description thereof will be omitted.

### "Photoelectric conversion layer 103B"

As illustrated in FIG. 14, the photoelectric conversion layer 103B includes a layer containing the upconverting particles 10B. The content of the upconverting particles 10B is preferably 10% by mass to 90% by mass with respect to the total mass of the photoelectric conversion layer 103B. The photoelectric conversion characteristic of the photoelectric conversion element 100B is improved by the content of the upconverting particles 10B being 10% by mass to 90% by mass with respect to the total mass of the photoelectric conversion layer 103B.

The photoelectric conversion layer 103B may contain a material such as a binder in addition to the upconverting particles 10B.

Although a larger number of current paths to be formed in the photoelectric conversion layer 103B is better, adjacent current paths may be electrically connected to each other or may not be connected to each other. Note that the "layer" in the present embodiment means a film formed in one or a plurality of film forming processes, is not limited to a flat film, and may not be integrated.

The upconverting particle 10B according to the third embodiment, the core portion 11A (that is, the upconverting micro precursor particle serving as a central particle) included in the upconverting particle 10B according to the third embodiment, and the photoelectric conversion element 100B have been described above. The upconverting particle 10B has a hexagonal columnar particle shape, a particle diameter of equal to or greater than 300 nm, a thickness of equal to or greater than 100 nm, and an aspect ratio as the particle diameter/the thickness of equal to or greater than 1.2 and equal to or less than 5.0, and thus has high upconverting light emission efficiency. Therefore, the photoelectric conversion element 100B using the upconverting particle 10B has a high photoelectric conversion characteristic.

Also, the core portion 11A has a hexagonal columnar particle shape, a particle diameter of equal to or greater than 300 nm, a thickness of equal to or greater than 100 nm, and an aspect ratio as the particle diameter/the thickness of equal to or greater than 1.2 and equal to or less than 5.0 and thus has high light emission quantum yield. Therefore, the upconverting particle 10B including the core portion 11A has high upconverting light emission efficiency.

In a case where the photoelectric conversion element 100B is irradiated with near-infrared light, the core portion 11A or the shell portion 12A in the upconverting particle 10B emits ultraviolet light. This ultraviolet light is absorbed by the TiO₂ layer 13, and electromotive force is generated. In the photoelectric conversion element 100B, it is possible to cause the inorganic semiconductor to perform direct absorption without dye sensitization or the like by using the upconverting particle 10B. Therefore, an excellent photoelectric conversion characteristic is exhibited. In addition, since the ultraviolet light generated by the core portion 11A or the shell portion 12A is absorbed by the TiO₂ layer 13, the photoelectric conversion characteristic becomes higher than that of the photoelectric conversion element 100A.

As described above, the upconverting particles 10, 10A, and 10B and the photoelectric conversion elements 100, 100A, and 100B according to the present embodiment can perform upconverting light emission even under low excitation light, such as sunlight irradiation, can obtain a good sensitization characteristic using weak light with a long wavelength, and can be inexpensively manufactured.

The upconverting particles 10, 10A, and 10B according to the present embodiment can be used for a liquid crystal display, a solid phase laser, a sensor, a solar cell, a biomarker, and the like. The photoelectric conversion elements 100, 100A and 100B according to the present embodiment can be used for a solar cell and a near-infrared detector.

In each of the upconverting particle according to the present embodiments, the core portion 11 can have a structure containing a doped rare earth atom (for example, ErYF₄), and the shell portion 12 can have a two-layer structure with a perovskite structure (for example, CsPbI₃/CsPbI₃). It is possible to directly absorb light with a wavelength converted by the core portion 11 by the perovskite structure by the shell portion 12 having the perovskite structure. Since the upconverting particle has a specific particle size, particle shape, and core-shell structure of the core-shell type upconverting microparticle of the present invention, excellent visible light (internal) quantum efficiency and near-infrared light quantum yield can be exhibited.

In each of the upconverting particle according to the present embodiments, the surface of the shell portion 12 may further include a second shell portion that is an organic compound having light absorption in a near-infrared or infrared region and contains a multidentate organic ligand having at least two or more coordination positions. Further, the surface of the second shell portion may further include a third shell portion that has coordination metal capable of forming a coordination bond with the multidentate organic ligand of the second shell portion. It is thus possible to increase detection sensitivity. Since the upconverting particle has a specific particle size, particle shape, and core-shell structure of the core-shell type upconverting microparticle of the present invention, excellent visible light (internal) quantum efficiency and near-infrared light quantum yield can be exhibited.

In each of the upconverting particles according to the present embodiments, the core portion 11 may contain Er³⁺, and the shell portion 12 may be configured of a plurality of layers. Furthermore, the core portion 11 may contain Er³⁺, the layer (adjacent layer) of the shell portion 12 adjacent to the core portion 11 may contain Yb³⁺, and the layer provided on the surface of the adjacent layer may contain Er³⁺. With such a configuration, it is possible to cause energy mitigation to intervene and to cause light to be efficiently emitted. Since the upconverting particle has a specific particle size, particle shape, and core-shell structure of the core-shell type upconverting microparticle of the present invention, excellent visible light (internal) quantum efficiency and near-infrared light quantum yield can be exhibited.

It is possible to appropriately replace the components in the embodiments with well-known components without departing from the gist of the present invention, and the above-described components may be appropriately combined.

### [Examples]

Hereinafter, the effects of the present invention will become more apparent from examples. Note that the present invention is not limited to the following examples and can be appropriately modified without changing the gist thereof.

### (Manufacturing of upconverting particle)

In accordance with the aforementioned method of manufacturing the upconverting particle, upconverting particles were manufactured specifically under the following conditions.

### (Example 1)

### (Upconverting micro precursor particles serving as central particles in present invention)

A core portion (that is, an upconverting micro precursor particle serving as a central particle) of a core-shell type upconverting microparticle was synthesized by the sol-gel method. Specifically, 0.975 mmol of Y oxide (Y₂O₃), 0.25 mmol of Yb oxide (Yb₂O₃), and 0.025 mmol of Er oxide (Er₂O₃) were mixed with 10 mL of trifluoroacetic acid and 10 mL of water. The resulting mixture was heated and stirred at 80°C under a reduced pressure. To powder obtained through evaporation to dryness, 2.5 mmol of sodium trifluoroacetate (NaCOOCF₃) was added. This was mixed with 7.5 mL of oleic acid and 7.5 mL of 1-octadecene. The obtained mixture was stirred at 100°C for 30 minutes under a reduced pressure (formation of the α phase), and then the mixture was stirred at 330°C for 60 minutes under a reduced pressure in order to cause phase transition of the mixture from the α phase to the β phase. The reduced pressure was achieved through deaeration with a vacuum pump so as to achieve a predetermined pressure (0.01 Pa) or less. After stirring, the mixture was cooled to 80°C, and then 20 mL of ethanol was added thereto. Upconverting micro precursor particles (NaYF₄: Yb, Er) serving as central particles of Example 1 were separated from the resulting mixture by a centrifugal method. The upconverting micro precursor particles had a particle diameter of 600 nm and a thickness of 150 nm.

### (Comparative Example 1-1) (Nanoparticles)

0.975 mmol of Y oxide (Y₂O₃), 0.25 mmol of Yb oxide (Yb₂O₃), and 0.025 mmol of Er oxide (Er₂O₃) were mixed with 10 mL of trifluoroacetic acid and 10 mL of water. The resulting mixture was heated and stirred at 80°C under a reduced pressure. To powder obtained through evaporation to dryness, 5.0 mmol of sodium trifluoroacetate (NaCOOCF₃) was added. This was mixed with 7.5 mL of oleic acid and 7.5 mL of 1-octadecene. The obtained mixture was stirred at 100°C for 30 minutes under a reduced pressure (formation of the α phase), and then the mixture was stirred at 330°C for 15 minutes under a reduced pressure in order to cause phase transition of the mixture from the α phase to the β phase. The reduced pressure was achieved through deaeration with a vacuum pump so as to achieve a predetermined pressure (0.01 Pa) or less. After stirring, the mixture was cooled to 80°C, and then 20 mL of ethanol was added thereto. From the resulting mixture, nanoparticles of Comparative Example 1-1 (NaYF₄: Yb, Er) were separated by the centrifugal method. The nanoparticles had a particle diameter of 100 nm and a thickness of 50 nm.

### (Comparative Example 1-2)

### (Cubic crystal (α-phase) particles) No. 1

0.975 mmol of Y oxide (Y₂O₃), 0.25 mmol of Yb oxide (Yb₂O₃), and 0.025 mmol of Er oxide (Er₂O₃) were mixed with 10 mL of trifluoroacetic acid and 10 mL of water. The resulting mixture was heated and stirred at 80°C under a reduced pressure. To powder obtained through evaporation to dryness, 2.5 mmol of sodium trifluoroacetate (NaCOOCF₃) was added. This was mixed with 7.5 mL of oleic acid and 7.5 mL of 1-octadecene. The obtained mixture was stirred at 100°C for 30 minutes under a reduced pressure (formation of the α phase), and then the mixture was stirred at 330°C for 10 minutes under a reduced pressure. The reduced pressure was achieved through deaeration with a vacuum pump so as to achieve a predetermined pressure (0.01 Pa) or less. After stirring, the mixture was cooled to 80°C, and then 20 mL of ethanol was added thereto. Cubic crystal (α-phase) particles of Comparative Example 1-2 (NaYF₄: Yb, Er) were separated from the resulting mixture by the centrifugal method.

### (Example 2-1) Upconverting micro precursor particles serving as central particles in the core-shell type upconverting microparticles (No. 1: Formation of first shell, No. 2: Formation of second shell) of the present invention

0.7375 mmol of Y oxide (Y₂O₃), 0.50 mmol of Yb oxide (Yb₂O₃), and 0.0125 mmol of Tm oxide (Tm₂O₃) were mixed with 10 mL of trifluoroacetic acid and 10 mL of water. The resulting mixture was heated and stirred at 80°C under a reduced pressure. To powder obtained through evaporation to dryness, 2.65 mmol of sodium trifluoroacetate (NaCOOCF₃) was added. This was mixed with 7.5 mL of oleic acid and 7.5 mL of 1-octadecene. The obtained mixture was stirred at 100°C for 30 minutes under a reduced pressure (formation of the α phase), and then the mixture was stirred at 330°C for 60 minutes under a reduced pressure in order to cause phase transition of the mixture from the α phase to the β phase. The reduced pressure was achieved through deaeration with a vacuum pump so as to achieve a predetermined pressure (0.01 Pa) or less. After stirring, the mixture was cooled to 80°C, and then 20 mL of ethanol was added thereto. Upconverting micro precursor particles (NaYF₄: Yb, Tm (core)) serving as central particles of Example 2-1 were separated from the resulting mixture by a centrifugal method. The upconverting microparticles had a particle diameter of 850 nm and a thickness of 570 nm.

### (Example 2-2)

### Core-shell type upconverting microparticles of present invention No. 1

First coating layers were formed on the upconverting micro precursor particles serving as the central particles of Example 2-1 separated as described above by the sol-gel method. Specifically, 0.5 mmol of Y oxide (Y₂O₃) was mixed with 5 mL of trifluoroacetic acid and 5 mL of water. The resulting mixture was heated and stirred at 80°C under a reduced pressure. To powder obtained through evaporation to dryness, 11.0 mmol of central particle and 2.0 mmol of sodium trifluoroacetate (NaCOOCF₃) were added, and the resulting mixture was mixed with 7.5 mL of oleic acid and 7.5 mL of 1-octadecene. The obtained mixture was stirred at 100°C for 30 minutes under a reduced pressure, and then the mixture was stirred at 300°C for 60 minutes under a reduced pressure. After stirring, the mixture was cooled to 80°C, and then 20 mL of ethanol was added thereto. Core-shell type upconverting microparticles (NaYF₄: Yb, Tm (core), NaYF₄ (shell) × 1) of Example 2-2 were separated from the resulting mixture by the centrifugal method. The reduced pressure was achieved through deaeration with a vacuum pump so as to achieve a predetermined pressure (0.01 Pa) or less. The particle diameter and the thickness of the core-shell type upconverting microparticles of Example 2-2 were obtained by analyzing an SEM image obtained from SEM observation in accordance with the above-described measurement method. The core-shell type upconverting microparticles of Example 2-2 had a particle diameter of 1000 nm and a thickness of 590 nm. The shell/core ratio was 5.7.

### (Example 2-3)

### Core-shell type upconverting microparticles of present invention No. 2

Second coating layers were formed on the core-shell type upconverting microparticles of Example 2-2 including the first coating layers separated as described above by the sol-gel method. Specifically, 0.5 mmol of Y oxide (Y₂O₃) was mixed with 5 mL of trifluoroacetic acid and 5 mL of water. The resulting mixture was heated and stirred at 80°C under a reduced pressure. To powder obtained through evaporation to dryness, 11.0 mmol of central particle and 2.0 mmol of sodium trifluoroacetate (NaCOOCF₃) were added, and the resulting mixture was mixed with 7.5 mL of oleic acid and 7.5 mL of 1-octadecene. The obtained mixture was stirred at 100°C for 30 minutes under a reduced pressure, and then the mixture was stirred at 300°C for 60 minutes under a reduced pressure. After stirring, the mixture was cooled to 80°C, and then 20 mL of ethanol was added thereto. Core-shell type upconverting microparticles (NaYF₄: Yb, Tm (core), NaYF₄ (shell) × 2) of Example 2-3 were separated from the resulting mixture by the centrifugal method. The reduced pressure was achieved through deaeration with a vacuum pump so as to achieve a predetermined pressure (0.01 Pa) or less. The particle diameter and the thickness of the core-shell type upconverting microparticles of Example 2-3 were obtained by analyzing an SEM image obtained from SEM observation in accordance with the above-described measurement method. The core-shell type upconverting microparticles of Example 2-3 had a particle diameter of 1100 nm and a thickness of 600 nm. The shell/core ratio was 3.4.

### (Comparative Example 2)

### α cubic crystal (a-phase) particles No. 2

0.7375 mmol of Y oxide (Y₂O₃), 0.50 mmol of Yb oxide (Yb₂O₃), and 0.0125 mmol of Tm oxide (Tm₂O₃) were mixed with 10 mL of trifluoroacetic acid and 10 mL of water. The resulting mixture was heated and stirred at 80°C under a reduced pressure. To powder obtained through evaporation to dryness, 2.65 mmol of sodium trifluoroacetate (NaCOOCF₃) was added. This was mixed with 7.5 mL of oleic acid and 7.5 mL of 1-octadecene. The obtained mixture was stirred at 100°C for 30 minutes under a reduced pressure (formation of the α phase), and then the mixture was stirred at 330°C for 10 minutes under a reduced pressure. The reduced pressure was achieved through deaeration with a vacuum pump so as to achieve a predetermined pressure (0.01 Pa) or less. After stirring, the mixture was cooled to 80°C, and then 20 mL of ethanol was added thereto. Cubic crystal (α-phase) particles of Comparative Example 2 (NaYF₄: Yb, Er) were separated from the resulting mixture by the centrifugal method.

### (Example 3-1) Core-shell type upconverting microparticles of present invention No. 3

A core portion (that is, an upconverting micro precursor particle serving as a central particle) of a core-shell type upconverting microparticle was synthesized by the sol-gel method. Specifically, 0.744 mmol of Y oxide (Y₂O₃), 0.50 mmol of Yb oxide (Yb₂O₃), and 0.00625 mmol of Tm oxide (Tm₂O₃) were mixed with 10 mL of trifluoroacetic acid and 10 mL of water. The resulting mixture was heated and stirred at 80°C under a reduced pressure. To powder obtained through evaporation to dryness, 2.65 mmol of sodium trifluoroacetate (NaCOOCF₃) was added. This was mixed with 7.5 mL of oleic acid and 7.5 mL of 1-octadecene. The obtained mixture was stirred at 100°C for 30 minutes under a reduced pressure (formation of the α phase), and then the mixture was stirred at 330°C for 60 minutes under a reduced pressure in order to cause phase transition of the mixture from the α phase to the β phase. The reduced pressure was achieved through deaeration with a vacuum pump so as to achieve a predetermined pressure (0.01 Pa) or less. After stirring, the mixture was cooled to 80°C, and then 20 mL of ethanol was added thereto. Upconverting micro precursor particles serving as central particles of Example 3-1 were separated from the resulting mixture by the centrifugal method. The upconverting micro precursor particles had a particle diameter of 630 nm and a thickness of 420 nm.

First coating layers were formed on the upconverting micro precursor particles serving as the central particles of Example 3-1 separated as described above by the sol-gel method. Specifically, 0.30 mmol of Y oxide (Y₂O₃), 0.15 mmol of Yb oxide (Yb₂O₃), and 0.05 mmol of Nd oxide (Nd₂O₃) were mixed with 5 mL of trifluoroacetic acid and 5 mL of water. The resulting mixture was heated and stirred at 80°C under a reduced pressure. To powder obtained through evaporation to dryness, 2.65 mmol of sodium trifluoroacetate (NaCOOCF₃) was added. This was mixed with 7.5 mL of oleic acid and 7.5 mL of 1-octadecene. The obtained mixture was stirred at 100°C for 30 minutes under a reduced pressure (formation of the α phase), and then the mixture was stirred at 330°C for 60 minutes under a reduced pressure in order to cause phase transition of the mixture from the α phase to the β phase. The reduced pressure was achieved through deaeration with a vacuum pump so as to achieve a predetermined pressure (0.01 Pa) or less. After stirring, the mixture was cooled to 80°C, and then 20 mL of ethanol was added thereto. The core-shell type upconverting microparticles (NaYF₄: Yb, Tm (core), NaYF₄: Yb, Nd (shell)) of Example 3-1 were separated from the resulting mixture by the centrifugal method. The core-shell type upconverting microparticles including the first coating layers had a particle diameter of 850 nm and a thickness of 500 nm.

### (Example 3-2)

### Core-shell type upconverting microparticles of present invention No. 4

A core portion (that is, an upconverting micro precursor particle serving as a central particle) of a core-shell type upconverting microparticle was synthesized by the sol-gel method. Specifically, 0.75 mmol of Y oxide (Y₂O₃), 0.375 mmol of Yb oxide (Yb₂O₃), and 0.125 mmol of Nd oxide (Nd₂O₃) were mixed with 10 mL of trifluoroacetic acid and 10 mL of water. The resulting mixture was heated and stirred at 80°C under a reduced pressure. To powder obtained through evaporation to dryness, 2.65 mmol of sodium trifluoroacetate (NaCOOCF₃) was added. This was mixed with 7.5 mL of oleic acid and 7.5 mL of 1-octadecene. The obtained mixture was stirred at 100°C for 30 minutes under a reduced pressure (formation of the α phase), and then the mixture was stirred at 330°C for 60 minutes under a reduced pressure in order to cause phase transition of the mixture from the α phase to the β phase. The reduced pressure was achieved through deaeration with a vacuum pump so as to achieve a predetermined pressure (0.01 Pa) or less. After stirring, the mixture was cooled to 80°C, and then 20 mL of ethanol was added thereto. Upconverting micro precursor particles serving as central particles of Example 3-2 were separated from the resulting mixture by the centrifugal method. The upconverting micro precursor particles had a particle diameter of 300 nm and a thickness of 170 nm.

First coating layers were formed on the upconverting micro precursor particles serving as the central particles of Example 3-2 separated as described above by the sol-gel method. Specifically, 0.295 mmol of Y oxide (Y₂O₃), 0.20 mmol of Yb oxide (Yb₂O₃), and 0.005 mmol of Tm oxide (Tm₂O₃) were mixed with 5 mL of trifluoroacetic acid and 5 mL of water. The resulting mixture was heated and stirred at 80°C under a reduced pressure. To powder obtained through evaporation to dryness, 2.65 mmol of sodium trifluoroacetate (NaCOOCF₃) was added. This was mixed with 7.5 mL of oleic acid and 7.5 mL of 1-octadecene. The obtained mixture was stirred at 100°C for 30 minutes under a reduced pressure (formation of the α phase), and then the mixture was stirred at 330°C for 60 minutes under a reduced pressure in order to cause phase transition of the mixture from the α phase to the β phase. The reduced pressure was achieved through deaeration with a vacuum pump so as to achieve a predetermined pressure (0.01 Pa) or less. After stirring, the mixture was cooled to 80°C, and then 20 mL of ethanol was added thereto. The core-shell type upconverting microparticles (NaYF₄: Yb, Nd (core), NaYF₄: Yb, Tm (core)) of Example 3-2 were separated from the resulting mixture by the centrifugal method. The core-shell type upconverting microparticles including the first coating layers had a particle diameter of 400 nm and a thickness of 220 nm.

### (Example 4) TiO₂-coated core-shell type upconverting microparticles of present invention

A core portion (that is, an upconverting micro precursor particle serving as a central particle) of a core-shell type upconverting microparticle was synthesized by the sol-gel method. Specifically, 0.744 mmol of Y oxide (Y₂O₃), 0.50 mmol of Yb oxide (Yb₂O₃), and 0.00625 mmol of Tm oxide (Tm₂O₃) were mixed with 10 mL of trifluoroacetic acid and 10 mL of water. The resulting mixture was heated and stirred at 80°C under a reduced pressure. To powder obtained through evaporation to dryness, 2.65 mmol of sodium trifluoroacetate (NaCOOCF₃) was added. This was mixed with 7.5 mL of oleic acid and 7.5 mL of 1-octadecene. The obtained mixture was stirred at 100°C for 30 minutes under a reduced pressure (formation of the α phase), and then the mixture was stirred at 330°C for 60 minutes under a reduced pressure in order to cause phase transition of the mixture from the α phase to the β phase. The reduced pressure was achieved through deaeration with a vacuum pump so as to achieve a predetermined pressure (0.01 Pa) or less. After stirring, the mixture was cooled to 80°C, and then 20 mL of ethanol was added thereto. Upconverting micro precursor particles serving as central particles of Example 4 were separated from the resulting mixture by the centrifugal method. The upconverting micro precursor particles had a particle diameter of 630 nm and a thickness of 420 nm.

First coating layers were formed on the upconverting micro precursor particles serving as the central particles of Example 4 separated as described above by the sol-gel method. Specifically, 0.30 mmol of Y oxide (Y₂O₃), 0.15 mmol of Yb oxide (Yb₂O₃), and 0.05 mmol of Nd oxide (Nd₂O₃) were mixed with 5 mL of trifluoroacetic acid and 5 mL of water. The resulting mixture was heated and stirred at 80°C under a reduced pressure. To powder obtained through evaporation to dryness, 2.65 mmol of sodium trifluoroacetate (NaCOOCF₃) was added. This was mixed with 7.5 mL of oleic acid and 7.5 mL of 1-octadecene. The obtained mixture was stirred at 100°C for 30 minutes under a reduced pressure (formation of the α phase), and then the mixture was stirred at 330°C for 60 minutes under a reduced pressure in order to cause phase transition of the mixture from the α phase to the β phase. The reduced pressure was achieved through deaeration with a vacuum pump so as to achieve a predetermined pressure (0.01 Pa) or less. After stirring, the mixture was cooled to 80°C, and then 20 mL of ethanol was added thereto. The core-shell type upconverting microparticles (NaYF₄: Yb, Tm (core), NaYF₄: Yb, Nd (shell)) of Example 4 were separated from the resulting mixture by the centrifugal method. The core-shell type upconverting microparticles including the first coating layers had a particle diameter of 850 nm and a thickness of 500 nm.

TiO₂ layers were formed on the outermost layers of the core-shell type upconverting microparticles of Example 4 separated as described above. Specifically, 1 mmoL of coated particles was mixed with 20 mmol/L of ethanol solution of titanium diisopropoxide bis(acetylacetonate) [(CH₃)₂CHO]₂Ti(C₅H₇O₂)₂. The resulting mixture was stirred at 70°C for 1 hour. After stirring, the obtained solid was heated at 450°C for 1 hour to obtain TiO₂-coated core-shell type upconverting microparticles of Example 4. The TiO₂-coated core-shell type upconverting microparticles of Example 4 had a particle diameter of 860 nm and a thickness of 520 nm. Also, the shell (not including the TiO₂ layer)/core ratio was 0.35, and the shell (including the TiO₂ layer)/core ratio was 0.365. Moreover, the thickness of TiO₂ was 10 nm.

### (Example 5) Production of photoelectric conversion element of present invention

A conductive substrate with fluorine-doped tin oxide (FTO) provided on a glass substrate was prepared. A dispersion liquid containing the TiO₂-coated core-shell type upconverting microparticles of Example 4 and titanium oxide powder (particle diameter of equal to or less than 1 µm) was applied onto the substrate of the member by spin coating and was heated at 400°C, thereby obtaining a negative electrode substrate. 0.026 g of iodine and 0.166 g of potassium iodide were dissolved in 2 mL of ethylene glycol, thereby preparing an electrolytic solution. Then, a Pt film was formed on the glass substrate by vacuum deposition, thereby obtaining a positive electrode substrate. The positive electrode substrate and the negative electrode substrate were disposed such that FTO and Ag faced each other, and a gap between the positive electrode substrate and the negative electrode substrate was filled with an electrolyte solution (Electrolyte: I, solvent: ethylene glycol), thereby preparing a photoelectric conversion element.

The upconverting micro precursor particles serving as central particles of Example 1, core-shell type upconverting microparticles of Example 2-2, cubic crystal (α phase) particles of Comparative Example 1-2, and cubic crystal (α phase) particles of Comparative Example 2 were measured using an X-ray diffractometer.

### (Test Example 1) Light emission spectrum of each particle

Light emission spectral when the upconverting micro precursor particles serving as the central particles of Example 1, the upconverting micro precursor particles serving as the central particles of Example 2-1, the core-shell type upconverting microparticles of Example 2-2, the core-shell type upconverting microparticles of Example 2-3, the nanoparticles of Comparative Example 1-1, the cubic crystal (α-phase) particles of Comparative Example 1-2, and the cubic crystal (α-phase) particles of Comparative Example 2 were irradiated with near-infrared light having a wavelength of 980 nm was measured with an absolute PL quantum yield measuring apparatus manufactured by Hamamatsu Photonics K.K., and quantum efficiency was obtained from the obtained emission spectra. Similarly, the light emission spectra when the core-shell type upconverting microparticles of Example 3-1 and the core-shell type upconverting microparticles of Example 3-2 were irradiated with near-infrared light having a wavelength of 790 nm were measured with the absolute PL quantum yield measurement apparatus manufactured by Hamamatsu Photonics K.K., and quantum efficiency was obtained from the obtained emission spectra.

### (Test Example 2) SEM observation of each particle

SEM images were obtained by observing the respective particles of Example 1, Example 2-1, Example 3-1 (core, core shell), Example 3-2 (core, core shell), Comparative Examples 1-1 and 1-2, and Comparative Example 2 at a magnification of 150,000 times using a scanning electron microscope manufactured by Hitachi High-Tech Corporation.

### (Test Example 3) FT-IR measurement of each particle

FT-IR measurement of each of the particles (the particles of Example 1, Example 2-1, Comparative Example 1-2, and Comparative Example 2) was performed using a Fourier transform infrared spectrophotometer (FT-IR). The measurement was performed using a permeation method by mixing KBr and particles to prepare pellets.

### (Test Example 4) Response characteristics of photocurrent in photoelectric conversion element of present invention

Photoresponse characteristics of the photoelectric conversion element of Example 5 were measured. The voltage applied between the positive electrode layer and the negative electrode layer of the photoelectric conversion element was set to -0.5 V. The wavelength and the irradiance of light with which the photoelectric conversion element was irradiated were set to 808 nm and 10 mW/cm², respectively.

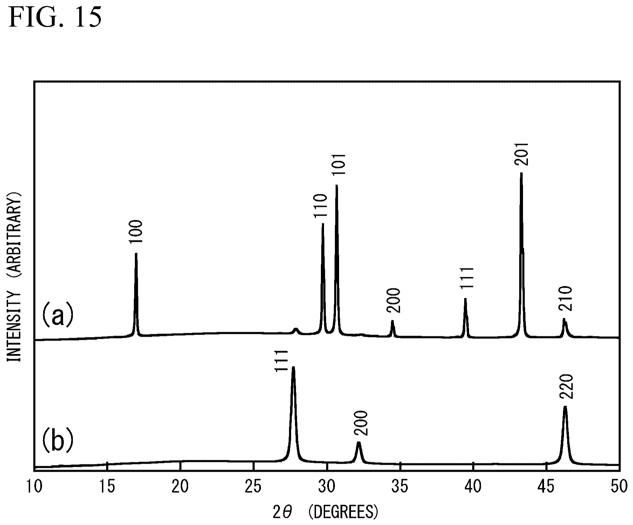

FIG. 15 is XRD patterns of Example 1 and Comparative Example 1-2. The horizontal axis in FIG. 15 is 20 (degrees), and the vertical axis in FIG. 15 is intensity (arbitrary). FIG. 15(a) is an XRD pattern of the up-conversion microparticles serving as the central particles in Example 1, and FIG. 15(b) is an XRD pattern of the cubic crystal (α-phase) particles in Comparative Example 1-2. It was confirmed in FIG. 15 that the upconverting microparticles serving as the central particles of Example 1 were in the β phase while the cubic crystal (α phase) particles of Comparative Example 1-2 were in the α phase.

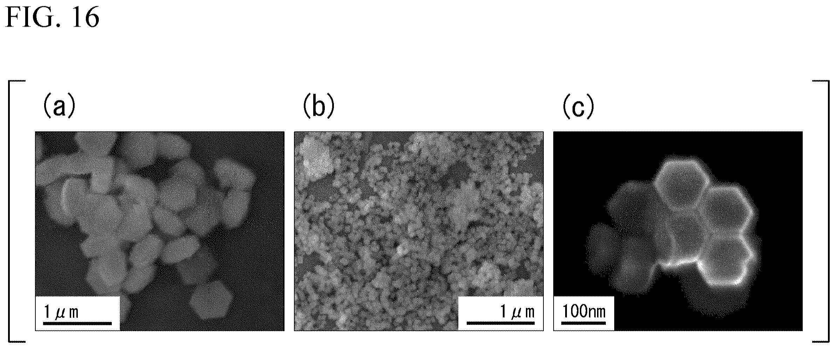

FIG. 16(a) is a SEM image of Example 1, FIG. 16(b) is a SEM image of nanoparticles of Comparative Example 1-1, and FIG. 16(c) shows a cubic particle of Comparative Example 1-2. The particle diameter and the thicknesses of the upconverting micro precursor particles estimated from the SEM image were 600 nm and 150 nm, respectively. The particle diameter and the thicknesses of the cubic crystal (α phase) particles of Comparative Example 2 estimated from the SEM image were 100 nm and 50 nm, respectively.

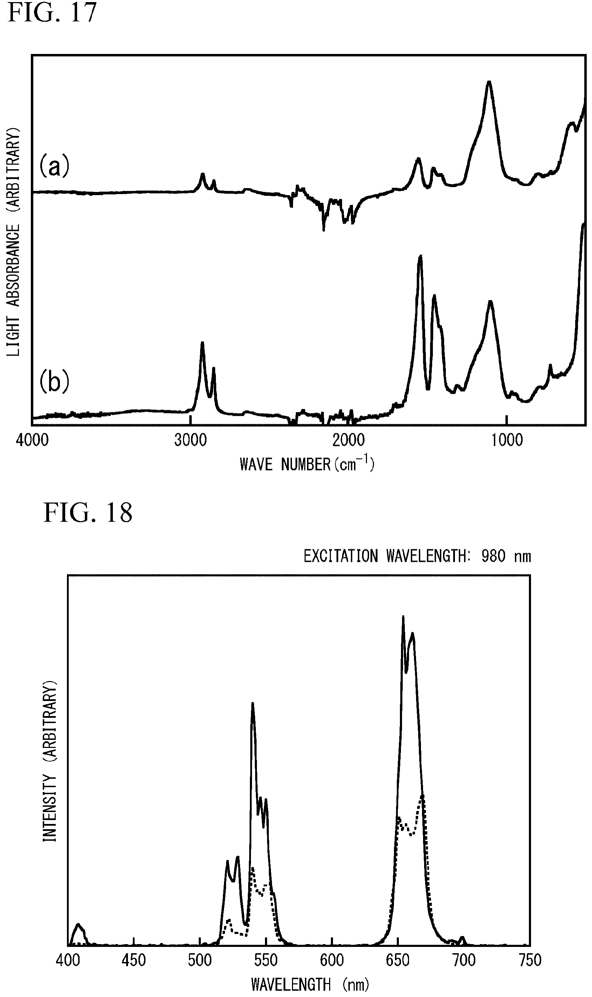

FIG. 17 shows FT-IR spectra of Example 1 (upconverting micro precursor particles) and Comparative Example 1-2 (cubic crystal (α-phase) particles). The horizontal axis represents a wave number (cm⁻¹), and the vertical axis represents absorbance (arbitrary). FIG. 17(a) shows an FT-IR spectrum of Example 1, and FIG. 17(b) shows an FT-IR spectrum of Comparative Example 1-2. As illustrated in FIG. 17, a decrease in absorbance at about 3000 cm⁻¹ to 2800 cm⁻¹ and about 1700 cm⁻¹ to 1400 cm⁻¹ was confirmed in the FT-IR spectrum of Example 1.

FIG. 18 shows light emission spectra of Example 1 and Comparative Example 1-2. In FIG. 18, the horizontal axis represents a wavelength (cm⁻¹), and the vertical axis represents intensity (arbitrary). The solid line indicates the light emission spectrum of Example 1, and the dotted line indicates the light emission spectrum of Comparative Example 1-2. As illustrated in FIG. 18, the particles of Example 1 having a large particle diameter had higher light emission intensity than the particles of Comparative Example 1-2.

The light emission quantum efficiency (%) of the particles of Example 1, Comparative Example 1-1, and Comparative Example 1-2 obtained on the basis of these results are shown in Table 1 (excitation wavelength of 980 nm). Since the upconverting microparticles serving as the central particles of Example 1 had a particle diameter of equal to or greater than 300 nm, a thickness of equal to or greater than 100 nm, and an aspect ratio as the particle diameter/the thickness of equal to or greater than 1.2 and equal to or less than 5.0, the light emission quantum efficiency thereof was significantly higher than those of the nanoparticles of Comparative Example 1-1 and the cubic crystal (α-phase) particles of Comparative Example 1-2.

**[Table 1]**

| | Example 1 | Comparative Example 1-1 | Comparative Example 1-2 |
|---|---|---|---|
| Light emission quantum yield (%) | 5.22 | 1.05 | 0.022 |

| | | | |
|---|---|---|---|
| Excitation wavelength: 980 nm | | | |

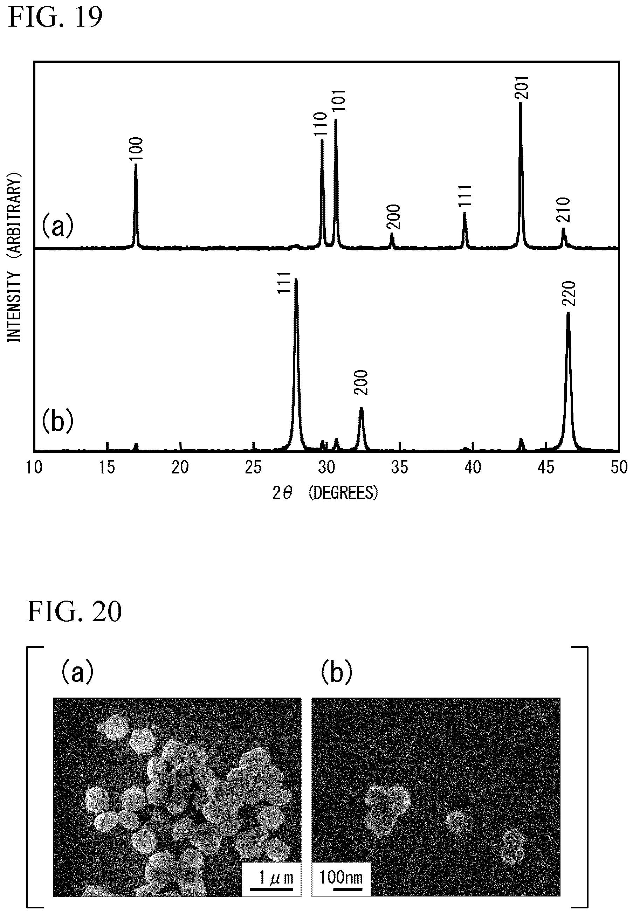

FIG. 19 shows XRD patterns of core portions (that is, upconverting micro precursor particles serving as central particles) contained in the core-shell type upconverting microparticles of Example 2-2 and cubic crystal (α-phase) particles of Comparative Example 2. The horizontal axis in FIG. 19 represents 20 (degrees), and the vertical axis in FIG. 19 represents intensity (arbitrary). FIG. 19(a) shows an XRD pattern of core portions (that is, upconverting micro precursor particles serving as central particles) contained in the core-shell type upconverting microparticles of Example 2-2, and FIG, 19(b) shows an XRD pattern of the cubic crystal (α phase) particles of Comparative Example 2. It was confirmed in FIG. 19 that the core portions in the core-shell type upconverting microparticles of Example 2-2 were in the β phase while the cubic crystal (α phase) particles of Comparative Example 2 were in the α phase.

FIG. 20(a) is a SEM image of Example 2-1, and FIG. 20(b) shows cubic crystal particles of Comparative Example 2. The particle diameter and the thicknesses of the upconverting micro precursor particles of Example 2-1 estimated from the SEM image were 850 nm and 570 nm, respectively. The particle diameter and the thicknesses of the cubic crystal (α phase) particles of Comparative Example 2 estimated from the SEM image were 100 nm and 50 nm, respectively.

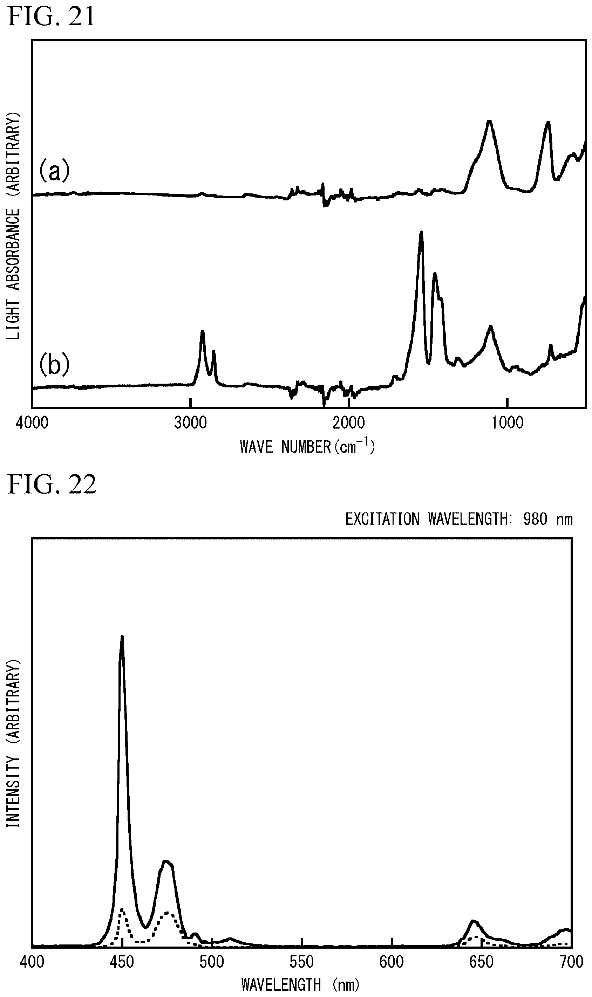

FIG. 21 shows FT-IR spectra of Example 2-1 (upconverting micro precursor particles) and Comparative Example 2 (cubic crystal (α-phase) particles). The horizontal axis represents a wave number (cm⁻¹), and the vertical axis represents absorbance (arbitrary). FIG. 21(a) shows an FT-IR spectrum of Example 2-1, and FIG. 21(b) shows an FT-IR spectrum of Comparative Example 2. As illustrated in FIG. 21, a decrease in absorbance at about 3000 cm⁻¹ to 2800 cm⁻¹ and about 1700 cm⁻¹ to 1400 cm⁻¹ was confirmed in the FT-IR spectrum of Example 2-1.

FIG. 22 shows light emission spectra of Example 2-1 and Comparative Example 2. In FIG. 22, the horizontal axis represents a wavelength (cm⁻¹), and the vertical axis represents intensity (arbitrary). The solid line indicates the light emission spectrum of Example 2-1, and the dotted line indicates the light emission spectrum of Comparative Example 2. As illustrated in FIG. 22, the particles of Example 2-1 having a large particle diameter had higher light emission intensity than the particles of Comparative Example 2.

Table 2 shows light emission quantum efficiency (%) of the particles in Examples 2-1, 2-2, and 2-3 and Comparative Example 2 (excitation wavelength of 980 nm). Since the particles in Examples 2-1, 2-2, and 2-3 have particle diameters of equal to or greater than 300 nm, thicknesses of equal to or greater than 100 nm, and aspect ratios as the particle diameters/the thicknesses of equal to or greater than 1.2 and equal to or less than 5.0, the light emission quantum efficiency thereof was significantly higher than those of the cubic crystal (α phase) particles of Comparative Example 2 and the cubic crystal (α phase) particles of Comparative Example 1-2. In addition, since the core-shell type upconverting microparticles of Examples 2-1 and 2-2 include the shell portions, the light emission quantum efficiency was further improved.

**[Table 2]**

| | Example 2-1 | Example 2-2 | Comparative Example 2-3 | Comparative Example 2 |
|---|---|---|---|---|
| Light emission quantum yield (%) | 8.77 | 11.8 | 12.6 | 0.49 |

| | | | | |
|---|---|---|---|---|
| Excitation wavelength: 980 nm | | | | |

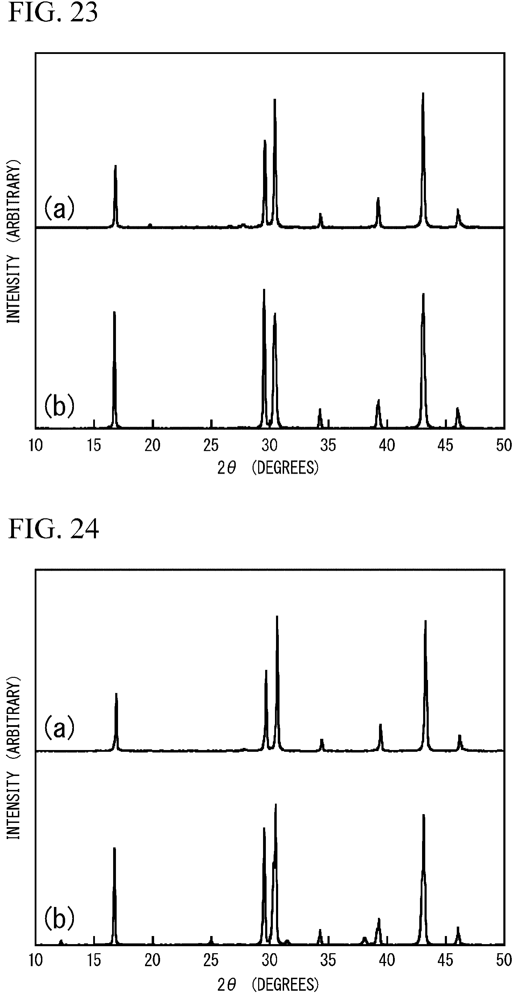

FIG. 23 is XRD patterns of the core and the core-shell of Example 3-1. In other words, these are XRD patterns of the core portions included in the core-shell type upconverting microparticles (that is, the upconverting micro precursor particles serving as the central particles) and the core-shell type upconverting microparticles. The horizontal axis in FIG. 23 represents 20 (degrees), and the vertical axis in FIG. 23 represents intensity (arbitrary). FIG. 23(a) shows an XRD pattern of the core portions (the upconverting microparticles of Example 3-1 serving as the central particles) included in the core-shell type upconverting microparticles of Example 3-1, and FIG. 23(b) shows an XRD pattern of the core-shell type upconverting microparticles of Example 3-2. It was confirmed in FIG. 23 that both the core-shell type upconverting microparticles and the core portions thereof in Example 3-1 are in the β phase.

FIG. 24 is XRD patterns of the core and the core-shell of Example 3-2. In other words, these are XRD patterns of the core portions included in the core-shell type upconverting microparticles (that is, the upconverting micro precursor particles serving as the central particles) and the core-shell type upconverting microparticles. The horizontal axis in FIG. 24 represents 20 (degrees), and the vertical axis in FIG. 24 represents intensity (arbitrary). FIG. 24(a) shows an XRD pattern of the core portions (the upconverting microparticles of Example 3-2 serving as the central particles) included in the core-shell type upconverting microparticles of Example 3-2, and FIG. 24(b) shows an XRD pattern of the core-shell type upconverting microparticles of Example 3-2. It was confirmed in FIG. 24 that both the core-shell type upconverting microparticles and the core portions thereof in Example 3-2 are in the β phase.

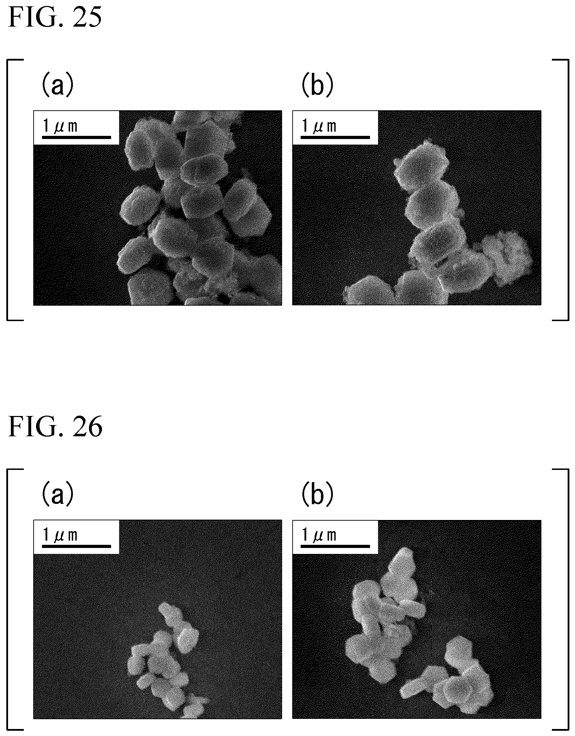

FIG. 25(a) is an SEM image of the cores of the core-shell type upconverting microparticles of Example 3-1, and FIG. 25(b) is an SEM image of the core-shell type upconverting microparticles of Example 3-1. The particle diameter and the thickness of the core-shell type upconverting microparticles including the first coating layers estimated from the SEM images in FIGS. 25(a) and 25(b) are 850 nm and 500 nm, respectively.

FIG. 26(a) is an SEM image of the cores of the core-shell type upconverting microparticles of Example 3-2, and FIG. 26(b) is an SEM image of the core-shell type upconverting microparticles of Example 3-2. The particle diameter and the thickness of the core-shell type upconverting microparticles including the first coating layers estimated from the SEM images in FIGS. 26(a) and 26(b) are 400 nm and 220 nm, respectively.

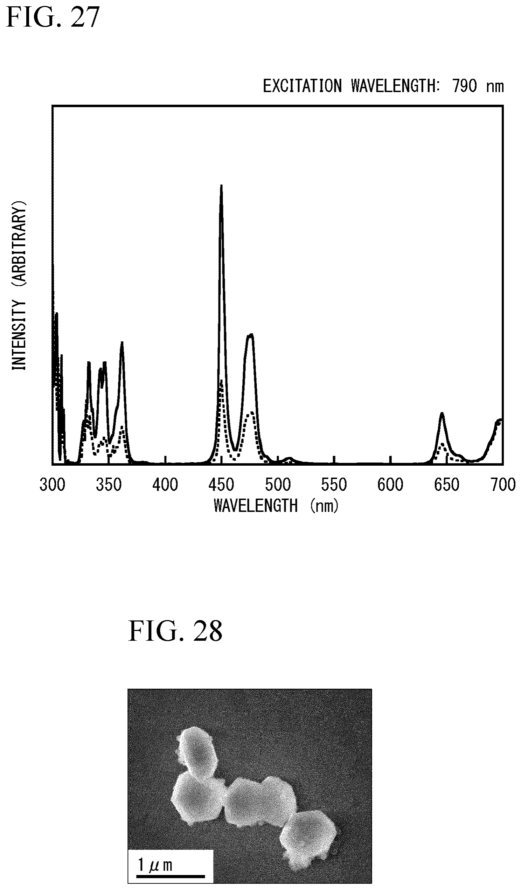

FIG. 27 shows light emission spectra of the core-shell type upconverting microparticles of Example 3-1 and Example 3-2. In FIG. 27, the horizontal axis represents a wavelength, and the vertical axis represents intensity. In FIG. 27, the solid line indicates a light emission spectrum of the core-shell type upconverting microparticles of Example 3-1 containing Nd in the shell portion. In FIG. 27, the dotted line indicates a light emission spectrum of the core-shell type upconverting microparticles of Example 3-2 containing Nd in the core portion. It was confirmed that ultraviolet light was emitted in both Example 3-1 and Example 3-2. The light emission quantum efficiency of Example 3-1 was 0.06%, and the external quantum efficiency of Example 3-2 was 0.01%. It was confirmed that ultraviolet light emission with high quantum efficiency was possible by containing Nd and Tm and containing Yb in the core portion and the shell portion. In addition, higher light emission quantum efficiency was exhibited when Nd was contained in the shell portion and Tm was contained in the core portion.

**[Table 3]**

| | Example 3-1 | Example 3-2 |
|---|---|---|
| Light emission quantum yield (%) | 0.06 | 0.01 |

| | | |
|---|---|---|
| Excitation wavelength: 790 nm | | |

FIG. 28 is an SEM image of Example 4. The particle diameter and the thickness of the TiO₂-coated core-shell type upconverting microparticles estimated from the obtained SEM image of Example 4 and the like were 860 nm and 520 nm, respectively. Also, the shell (not including the TiO₂ layer)/core ratio measured by the aforementioned method was 0.35, and the shell (including the TiO₂ layer)/core ratio was 0.365. Moreover, the thickness of TiO₂ was 10 nm.

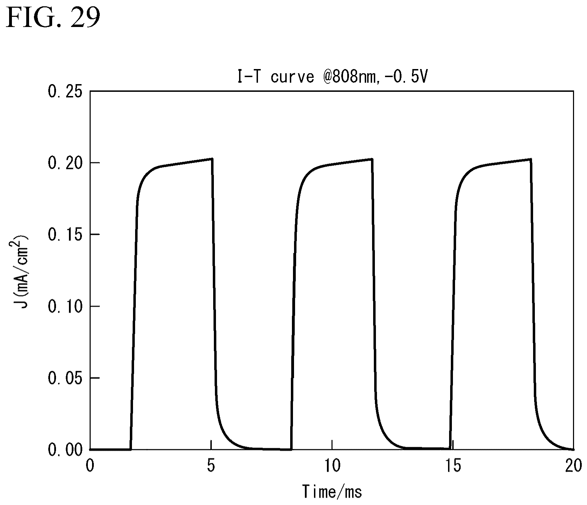

FIG. 29 is a graph showing a response speed of a photocurrent obtained by irradiating the photoelectric conversion element of Example 5 with light at a predetermined timing. The horizontal axis of the graph represents elapsed time (s), and the vertical axis of the graph represents a photocurrent (mA/cm²). The photocurrent exhibited instantaneous rising and falling in accordance with on and off of the voltage, and it was found that a sufficient response speed was able to be realized.

### [Industrial applicability]

According to the core-shell type upconverting microparticle, the upconverting micro precursor particle, a sensitizing core-shell type upconverting microparticle, a TiO₂-coated core-shell type upconverting microparticle, the near-infrared detector, the photoelectric conversion element, and the method of manufacturing the core-shell type upconverting microparticle of the present disclosure, it is possible to achieve upconverting light emission even under low excitation light, such as sunlight irradiation, to obtain a better sensitization characteristic using weak light with a long wavelength, and to thereby achieve high industrial applicability.

### [Reference Signs List]

10 Core-shell type upconverting microparticle
11 Core portion
12 Shell portion
100 Photoelectric conversion element
101 Positive electrode layer
102 Negative electrode layer
103 Photoelectric conversion layer
104 First layer
105 Second layer
106 Third layer

## Claims

1. A core-shell type upconverting microparticle that is an upconverting particle comprising: a core portion; and a shell portion that covers the core portion,
wherein the particle has a hexagonal columnar shape,
a particle diameter of equal to or greater than 300 nm, and
a thickness of equal to or greater than 100 nm, and
an aspect ratio as the particle diameter/the thickness is equal to or greater than 1.2 and equal to or less than 5.0.

2. The core-shell type upconverting microparticle according to claim 1, wherein the particle diameter is equal to or greater than 500 nm, and the thickness is equal to or greater than 300 nm.

3. The core-shell type upconverting microparticle according to claim 1, wherein the aspect ratio is equal to or greater than 1.2 and equal to or less than 3.0.

4. The core-shell type upconverting microparticle according to claim 1, wherein the aspect ratio is equal to or greater than 1.5 and equal to or less than 2.0.

5. The core-shell type upconverting microparticle according to claim 1, wherein a shell/core ratio that is a ratio of a width of the shell portion and a diameter length of the core portion of the upconverting particle is equal to or greater than 0.01 and equal to or less than 10.00.

6. The core-shell type upconverting microparticle according to claim 5, wherein the shell/core ratio is equal to or greater than 0.10 and equal to or less than 2.00.

7. The core-shell type upconverting microparticle according to claim 1,
wherein a crystal lattice as a host of the core portion and a crystal lattice as a host of the shell portion are composed of a same component,
the core portion contains doped rare earth atoms as guests, and
the shell portion does not contain doped rare earth atoms.

8. The core-shell type upconverting microparticle according to claim 7, wherein the shell portion does not cause energy transfer.

9. The core-shell type upconverting microparticle according to claim 7, wherein the core portion contains both light-absorbing sensitizing atoms and light-emitting activating atoms as the doped rare earth atoms.

10. The core-shell type upconverting microparticle according to claim 9,
wherein the light-absorbing sensitizing atoms are
trivalent rare earth atoms that have an f orbital energy level, and
absorb near-infrared light and cause an electron in a ground state to be excited to the f orbital energy level, and
the light-emitting activating atoms are
trivalent rare earth atoms that have a plurality of energy levels,
cause multiphoton multistep excitation by energy at the f orbital energy level that the light-absorbing sensitizing atoms have after the excitation being passed,
consequently excite an electron to a high energy level corresponding to an energy of equal to or greater than the f orbital energy level through the multiphoton multistep excitation, which is required for light emission in a visible light region, and
enable the electron excited to the high energy level to emit light in the visible light region as light of the energy of equal to or greater than the f orbital energy level by accompanying light emission when the electron returns to the ground state.

11. The core-shell type upconverting microparticle according to claim 9, wherein the crystal lattice is NaYF₄, the light-absorbing sensitizing atoms are one or more kinds selected from the group consisting of Yb and Nd, and the light-emitting activating atoms are one or more kinds selected from the group consisting of Tm, Er, and Ho.

12. The core-shell type upconverting microparticle according to claim 7, wherein Nd is contained as the doped rare earth atom.

13. The core-shell type upconverting microparticle according to claim 7, wherein the doped rare earth atoms are a pair of either both Nd and Yb atoms or both Tm and Yb atoms.

14. The core-shell type upconverting microparticle according to claim 1,
wherein a crystal lattice as a host of the core portion and a crystal lattice as a host of the shell portion are composed of a same component,
the core portion contains first doped rare earth atoms as guests, and
the shell portion contains second doped rare earth atoms, which are different from the first doped rare earth atoms of the core portion, as guests.

15. The core-shell type upconverting microparticle according to claim 14, wherein the shell portion causes energy transfer.

16. The core-shell type upconverting microparticle according to claim 14, wherein both light-absorbing sensitizing atoms and light-emitting activating atoms are contained as the first doped rare earth atoms or the second doped rare earth atoms.

17. The core-shell type upconverting microparticle according to claim 16, wherein the light-absorbing sensitizing atoms are one or more kinds selected from the group consisting of Yb and Nd, and the light-emitting activating atoms contain one or more kinds selected from the group consisting of Tm, Er, and Ho.

18. The core-shell type upconverting microparticle according to claim 14, wherein the first doped rare earth atoms or the second doped rare earth atoms contain Nd.

19. The core-shell type upconverting microparticle according to claim 14,
wherein the crystal lattice is NaYF₄,
the first doped rare earth atoms are a pair of either both Nd and Yb atoms or both Tm and Yb atoms, and
the second doped rare earth atoms are a pair of both Nd and Yb atoms or both Tm and Yb atoms, which is a pair different from the first doped rare earth atoms.

20. The core-shell type upconverting microparticle according to claim 14, wherein in order to cause energy transfer from the first doped rare earth atoms to the second doped rare earth atoms, a first energy level that is an energy level of the first doped rare earth atoms is different from a second energy level that is an energy level of the second doped rare earth atoms.

21. The core-shell type upconverting microparticle according to claim 20,
wherein third doped rare earth atoms that are doped rare earth atoms that are different from the first doped rare earth atoms and the second doped rare earth atoms are further present as guests of at least one of the core portion and the shell portion, and
a third energy level that is an energy level of the third doped rare earth atoms is located between the energy level of the first doped rare earth atoms and the energy level of the second doped rare earth atoms.

22. The core-shell type upconverting microparticle according to claim 21,
wherein the second doped rare earth atoms have a plurality of energy levels after excitation at positions higher than an energy level before excitation at which the second doped rare earth atoms receive energy transferred from the first doped rare earth atoms or the third doped rare earth atoms, and
an energy gap between the energy level before excitation and one of the energy levels after excitation is equal to the transferred energy.

23. The core-shell type upconverting microparticle according to claim 1,
wherein doped rare earth atoms are contained,
the doped rare earth atoms are both light-absorbing sensitizing atoms and light-emitting activating atoms,
the light-absorbing sensitizing atoms are
trivalent rare earth atoms that have an f orbital energy level, and
absorb near-infrared light and cause an electron in a ground state to be excited to the f orbital energy level, and
the light-emitting activating atoms are
trivalent rare earth atoms that have a plurality of energy levels,
cause multiphoton multistep excitation by energy at the f orbital energy level that the light-absorbing sensitizing atoms have after the excitation being passed,
consequently excite an electron to a high energy level corresponding to an energy of equal to or greater than the f orbital energy level through the multiphoton multistep excitation, which is required for light emission in a visible light region, and
enable the electron excited to the high energy level to emit light in the visible light region as light of the energy of equal to or greater than the f orbital energy level by accompanying light emission when the electron returns to the ground state.

24. The core-shell type upconverting microparticle according to claim 23, wherein the light-absorbing sensitizing atoms are Yb, the light-emitting activating atoms are Er, and the multiphoton multistep excitation is two-photon two-step excitation.

25. The core-shell type upconverting microparticle according to claim 23, wherein the light-absorbing sensitizing atoms are Yb, the light-emitting activating atoms are Tm, and the multiphoton multistep excitation is three-photon three-step excitation.

26. The core-shell type upconverting microparticle according to claim 23, wherein the light-absorbing sensitizing atoms are Yb, the light-emitting activating atoms are Tm, and the multiphoton multistep excitation is two-photon two-step excitation.

27. The core-shell type upconverting microparticle according to claim 23, wherein one of the light-absorbing sensitizing atoms is Nd, and the other light-absorbing sensitizing atoms is one or more kinds selected from the group consisting of Er, Tm, and Ho.

28. A sensitizing core-shell type upconverting microparticle that is an upconverting particle comprising: a core portion; and a shell portion that covers the core portion,
wherein the particle has a hexagonal columnar shape,
a particle diameter of equal to or greater than 500 nm, and
a thickness of equal to or greater than 300 nm, and
an aspect ratio as the particle diameter/the thickness is equal to or greater than 1.2 and equal to or less than 3.0,
the core portion contains a pair of either both Nd and Yb atoms or both Tm and Yb atoms, and
the shell portion contains a pair of both Nd and Yb atoms or both Tm and Yb atoms, which is different from the pair included in the core portion.

29. The sensitizing core-shell type upconverting microparticle according to claim 28,
wherein the core portion contains both Nd and Yb atoms, and
the shell portion contains both Tm and Yb atoms.

30. The sensitizing core-shell type upconverting microparticle according to claim 28,
wherein the core portion contains both Tm and Yb atoms, and
the shell portion contains both Nd and Yb atoms.

31. A photoelectric conversion element comprising:
a transparent conductive film that serves as a negative electrode; a TiO₂ layer that contains the sensitizing core-shell type upconverting microparticle according to claim 28; an electrolyte layer; a hole transport layer; and an Ag layer that serves as a positive electrode, the transparent conductive film, the TiO₂ layer, the electrolyte layer, the hole transport layer, and the Ag layer being stacked in this order.

32. A TiO₂-coated core-shell type upconverting microparticle, wherein an outermost layer of the sensitizing core-shell type upconverting microparticle according to claim 28 or the core-shell type upconverting microparticle according to claim 1 is a TiO₂ layer composed of TiO₂.

33. A near-infrared detector comprising, in a photoelectric conversion layer:
a layer formed of the TiO₂-coated core-shell type upconverting microparticle according to claim 32.

34. A near-infrared detector comprising, in a photoelectric conversion layer:
a TiO₂ layer that contains either the sensitizing core-shell type upconverting microparticle according to claim 28 or the core-shell type upconverting microparticle according to claim 1.

35. A photoelectric conversion element comprising:
a transparent conductive film that serves as a negative electrode;
a layer formed of the TiO₂-coated core-shell type upconverting microparticle according to claim 32;
an electrolyte layer or a hole transport layer; and
an Ag layer that serves as a positive electrode,
the transparent conductive film, the layer formed of the TiO₂-coated core-shell type upconverting microparticle according to claim 32, the electrolyte layer or the hole transport layer, and the Ag layer being stacked in this order.

36. A method of manufacturing the core-shell type upconverting microparticle according to claim 1, the method comprising: a first step of forming the core portion by causing a crystal to grow under a condition of a range of 50°C to 500°C by a sol-gel method; and
a second step of causing a crystal constituting the shell portion to grow on a surface of the core portion by a sol-gel method under a condition of a range of 50°C to 500°C.

37. The method of manufacturing the core-shell type upconverting microparticle according to claim 36, wherein crystal growth in the first step is performed by a heating operation including formation of a cubic crystal and phase transition from the cubic crystal to a hexagonal crystal.

38. The method of manufacturing the core-shell type upconverting microparticle according to claim 37, wherein the heating operation in the first step is performed until an integrated temperature as a heating condition for the phase transition exceeds an integrated temperature as a heating condition for the formation of the cubic crystal.

39. The method of manufacturing the core-shell type upconverting microparticle according to claim 37, wherein the heating operation in the first step is performed with a degassing operation for maintaining a preset degree of vacuum.

40. The method of manufacturing the core-shell type upconverting microparticle according to claim 36, wherein a crystal lattice constituting the core portion and a crystal lattice constituting the shell portion are composed of a same component.

41. An upconverting micro precursor particle that is a central particle capable of serving as the core portion included in the core-shell type upconverting microparticle according to claim 1,
wherein the particle has a hexagonal columnar shape,
a particle diameter of equal to or greater than 300 nm, and
a thickness of equal to or greater than 100 nm, and
an aspect ratio as the particle diameter/the thickness is equal to or greater than 1.2 and equal to or less than 5.0.

42. The upconverting micro precursor particle according to claim 41, wherein a crystal is caused to grow by a sol-gel method under a condition of a range of 50°C to 500°C.

43. The upconverting micro precursor particle according to claim 42, wherein a long-chain organic molecule used as a gelling agent in the sol-gel method remains on or adheres to and is present on a surface of the particle even after crystal growth by a heating operation.
